# EUROPEAN PATENT APPLICATION

(11) **EP 4 712 711 A1**
(43) Date of publication of application: **18.03.2026**
(21) Application number: 25184162.3
(22) Date of filing: 20.06.2025
(51) Int. Cl.: H05K 7/20

(54) **ENERGY STORAGE CONVERTER AND ENERGY STORAGE SYSTEM**

(30) Priority: 27.04.2025 CN 202510537981
(71) Applicant: Zhejiang Jinko Energy Storage Co., Ltd., Jiaxing, Zhejiang (CN)
(72) Inventor: YU, Jian, JIAXING (CN); CHENG, Min, JIAXING (CN); ZHANG, Luhua, JIAXING (CN); SUN, Xuebing, JIAXING (CN); XU, Guodong, JIAXING (CN); LU, Yang, JIAXING (CN)
(74) Representative: Algemeen Octrooi- en Merkenbureau B.V.

(57) **Abstract**

The present disclosure relates to the technical field of energy storage, and, in particular, to an energy storage converter and an energy storage system. In embodiments of the present disclosure, a first cavity of a housing is configured to include a first region and a second region which are arranged along a first direction, an airflow generation apparatus can generate a first airflow flowing through the first region and a second airflow flowing through the second region, and the first airflow and the second airflow both flow in from a first side of the first cavity and flow out from a second side of the first cavity, so that the first region can be subjected to heat management by using the first airflow, and the second region can be subjected to heat management by using the second airflow. Meanwhile, since an average heat generation of devices arranged in the first region is greater than an average heat generation of devices arranged in the second region, more of the first airflow can flow into and flow out of a first channel defined by a cover by arranging the cover in the first region, so that a heat management effect of the first region can be improved, and then, a heat management effect can be improved on the whole.

## Description

### TECHNICAL FIELD

The present disclosure relates to the technical field of energy storage, and, in particular, to an energy storage converter and an energy storage system.

### BACKGROUND

With the development of an energy storage system, the power of an energy storage converter is continuously increased, and the power consumption of internal devices thereof is also continuously increased, so that the heat productivity of the devices is also continuously increased, and then, a higher requirement is put forward on the heat management effect of the energy storage converter.

### SUMMARY

Based on this, it is necessary to provide an energy storage converter and an energy storage system to improve the heat management effect of the energy storage converter.

According to an aspect of the present disclosure, embodiments of the present disclosure provide an energy storage converter, including: a housing having a first cavity, the first cavity including a first region and a second region arranged along a first direction, the first cavity having a first side and a second side oppositely arranged along a second direction, and the first direction and the second direction intersecting with each other; a plurality of devices at least arranged in the first region and the second region, an average heat generation of all the devices arranged in the first region being greater than an average heat generation of all the devices arranged in the second region; an airflow generation apparatus arranged in the first cavity, the airflow generation apparatus being configured to generate a first airflow flowing through the first region and a second airflow flowing through the second region, and the first airflow and the second airflow being configured to flow in from the first side and out from the second side; and a cover arranged in the first region and defining a first channel, an airflow path defined by the first channel forming at least a part of a flow path of the first airflow, and at least some of the devices located in the first region being located within the cover.

In some embodiments, the energy storage converter further includes a first partition wall, and the first partition wall is arranged in the first cavity and divides the first cavity to define a first sub-cavity and a second sub-cavity which are arranged along a third direction; one part of each of the first sub-cavity and the second sub-cavity is located in the first region, and the other part thereof is located in the second region; the first partition wall is provided with an opening, the opening is located in the first region, and the opening is communicated with the first sub-cavity and the second sub-cavity; the cover is at least arranged in the first sub-cavity, and at least some of the devices arranged in the first sub-cavity and located in the first region are located in the cover; the opening is communicated with the interior of the cover, and an orthographic projection of the opening on a reference plane and an orthographic projection of the cover on the reference plane have an overlapped part; and the reference plane is a surface perpendicular to the third direction, and the first direction, the second direction and the third direction intersect with each other pairwise.

In some embodiments, in a direction from the first side to the second side, one part of the cover is arranged in the first sub-cavity, and at least a part of the other part of the cover extends into the second sub-cavity via the opening; and at least some of the devices arranged in the second sub-cavity are located within the cover.

In some embodiments, the cover has a stair portion; and the stair portion is configured to be able to direct the first airflow located in the first sub-cavity into the second sub-cavity via the opening.

In some embodiments, a part of the cover arranged in the first sub-cavity is defined as a first cover section, and a part of the cover extending into the second sub-cavity via the opening is defined as a second cover section; and the stair portion is defined at a junction of the first cover section and the second cover section.

In some embodiments, the cover has an avoiding portion; and an orthographic projection of the avoiding portion on the reference plane and an orthographic projection of the opening on the reference plane have an overlapped part.

In some embodiments, a part of the cover arranged in the first sub-cavity is defined as a first cover section, and a part of the cover extending into the second sub-cavity via the opening is defined as a second cover section; in a direction from the first sub-cavity to the second sub-cavity, the second cover section is located downstream of the first cover section to define the avoiding portion; and/or a notch portion is arranged in the cover along the first direction, and an orthographic projection of the notch portion on the reference plane and the orthographic projection of the opening on the reference plane have an overlapped part.

In some embodiments, a part of the cover arranged in the first sub-cavity is defined as a first cover section, and a part of the cover extending into the second sub-cavity via the opening is defined as a second cover section; and the first cover section is detachably connected to the second cover section.

In some embodiments, in the direction from the first side to the second side, the first partition wall is spaced apart from the first side of the first cavity to define an accommodating cavity for accommodating some of the devices; the first sub-cavity and the second sub-cavity are both communicated with the accommodating cavity; and in the direction from the first side to the second side, the accommodating cavity is located upstream of the first sub-cavity and the second sub-cavity, so that the first airflow flows into the first region via the accommodating cavity, and the second airflow flows into the second region via the accommodating cavity.

In some embodiments, the airflow generation apparatus includes a first generation unit; and the first generation unit includes: a first generation member arranged corresponding to an inlet of the first channel, the first generation member being configured to be able to deliver the first airflow to the first channel; and a second generation member arranged corresponding to an outlet of the first channel, the second generation member being configured to output the first airflow in the first channel.

In some embodiments, the energy storage converter further includes a temperature detection member; the temperature detection member is arranged corresponding to the opening, and the temperature detection member is configured to detect a temperature of the device exposed through the opening; and the first generation member is configured to be able to adjust a working state in response to detection information of the temperature detection member.

In some embodiments, an air guide port is arranged in the first partition wall, and the air guide port is communicated with the first sub-cavity and the second sub-cavity; and the air guide port is located upstream of the opening in the direction from the first side to the second side.

In some embodiments, the air guide port is located downstream of a target device in the direction from the first side to the second side; and the target device is a device located upstream of the opening in the direction from the first side to the second side among the devices arranged in the first sub-cavity and located in the first region and the cover.

In some embodiments, the devices arranged in the first sub-cavity and located in the first region and the cover are all located upstream of the opening in the direction from the first side to the second side.

In some embodiments, the energy storage converter further includes an air guide member; the air guide member is arranged at an edge of the air guide port and located in the second sub-cavity; the air guide member has a first end and a second end which are oppositely arranged along an extension direction of the air guide member, and the first end is connected to the edge of the air guide port; the first end is located upstream of the second end in the direction from the first side to the second side; a direction from the first end to the second end and the third direction intersect with each other.

In some embodiments, the energy storage converter further includes a second partition wall; the second partition wall is arranged in the housing and divides the housing to define a first cavity and a second cavity which are arranged along a third direction; in a direction from the second sub-cavity to the first sub-cavity, the second cavity is located upstream of the first cavity; the second cavity has a third side and a fourth side which are oppositely arranged along the second direction; the energy storage converter further includes an air cooling module arranged in the second cavity, and the air cooling module is configured to generate a third airflow flowing into the second cavity from the third side and flowing out from the fourth side; and a direction from the third side to the fourth side is the same as the direction from the first side to the second side.

In some embodiments, the second partition wall is provided with a first communication hole for communicating the first cavity and the second cavity; an orthographic projection of the first communication hole on the reference plane and an orthographic projection of an object device on the reference plane have an overlapped part; and the object device is a device arranged on a part of the second partition wall corresponding to the opening in the third direction.

In some embodiments, the energy storage converter further includes an object circuit board; the object circuit board is arranged in the first region and carried by the second partition wall; the object device is located on a side of the object circuit board away from the second partition wall, and a second communication hole communicated with the first communication hole is formed in the object circuit board; and an orthographic projection of the second communication hole on the reference plane and the orthographic projection of the object device on the reference plane have an overlapped part.

In some embodiments, the energy storage converter further includes a first circuit board, a second circuit board, a third circuit board and a fourth circuit board; all the devices include a plurality of devices which are respectively arranged on the first circuit board, the second circuit board, the third circuit board and the fourth circuit board; the first circuit board and the second circuit board are arranged in the second sub-cavity along the direction from the first side to the second side; along the direction from the second sub-cavity to the first sub-cavity, the second circuit board and the third circuit board are spaced apart, and the devices arranged on the third circuit board are exposed through the opening; the fourth circuit board is arranged in the first sub-cavity and located in the first region, and the fourth circuit board is carried on the first partition wall; and the second circuit board is electrically connected between the first circuit board and the third circuit board, and the third circuit board is electrically connected between the second circuit board and the fourth circuit board.

In some embodiments, the first circuit board is configured as a power board, the second circuit board is configured as a busbar board, the third circuit board is configured as an alternating current output board, and the fourth circuit board is configured as an electromagnetic interference suppression board.

In some embodiments, along the third direction, the second circuit board and the third circuit board are spaced apart and define a second channel; and the second sub-cavity is provided with a wall structure which is opposite to and spaced apart from the first sub-cavity along the third direction, the wall structure is provided with an air introduction hole cooperating with the second channel, and the air introduction hole is configured to introduce an airflow into the second channel.

In some embodiments, the energy storage converter further includes a second partition wall; the second partition wall is arranged in the housing and divides the housing to define a first cavity and a second cavity which are arranged along a third direction; in a direction from the second sub-cavity to the first sub-cavity, the second cavity is located upstream of the first cavity; the second cavity has a third side and a fourth side which are oppositely arranged along the second direction, and a direction from the third side to the fourth side is the same as the direction from the first side to the second side; the energy storage converter further includes an air cooling module arranged in the second cavity, and the air cooling module is configured to generate a third airflow flowing into the second cavity from the third side and flowing out from the fourth side; a side of the second partition wall towards the second sub-cavity constitutes the wall structure, and the air introduction hole is configured to introduce a part of the third airflow into the second channel.

In some embodiments, the second region includes a first sub-region located in the first sub-cavity and a second sub-region located in the second sub-cavity; and an average heat generation of all the devices arranged in the first sub-region is greater than an average heat generation of all the devices arranged in the second sub-region, and the second airflow generated by the airflow generation apparatus is configured to flow through at least the first sub-region.

In some embodiments, the second airflow generated by the airflow generation apparatus is configured to be able to flow through the first sub-region and the second sub-region; and a fluid path of the second airflow through the first sub-region and a fluid path of the second airflow through the second sub-region are arranged in the third direction.

In some embodiments, the airflow generation apparatus includes a second generation unit arranged in the second region; the second generation unit is located downstream of the first partition wall in the direction from the first side to the second side; and one part of an air inlet of the second generation unit is communicated with the first sub-cavity, and the other part of the air inlet of the second generation unit is communicated with the second sub-cavity.

In some embodiments, the air inlet of the second generation unit includes a first sub-inlet and a second sub-inlet which are communicated with each other; the first sub-inlet and the second sub-inlet are arranged along the third direction, the first sub-inlet is communicated with the first sub-cavity, and the second sub-inlet is communicated with the second sub-cavity; and an opening area of the first sub-inlet is greater than an opening area of the second sub-inlet.

In some embodiments, the first partition wall has a first edge and a second edge oppositely arranged in the second direction, and a direction from the first edge to the second edge is the same as the direction from the first side to the second side; and the opening is configured as a notch penetrating through at least the second edge.

In some embodiments, the first partition wall further has a third edge and a fourth edge oppositely arranged in the first direction, the third edge is farther from the second region than the fourth edge, and both the third edge and the fourth edge are connected between the first edge and the second edge; and the opening is configured as a notch penetrating through the second edge and the third edge.

In some embodiments, the first partition wall includes a first partition portion and a second partition portion connected to each other, the first partition portion is located in the first region, and the second partition portion is located in the second region; and the first partition portion and the opening are arranged in sequence along a direction from the first edge to the second edge.

According to another aspect of the present disclosure, embodiments of the present disclosure provide an energy storage system, including the energy storage converter according to any of the above embodiments.

In the energy storage converter and the energy storage system, the energy storage converter at least includes the housing, the plurality of devices, the airflow generation apparatus and the cover, the first cavity of the housing is configured to include the first region and the second region which are arranged along the first direction, the airflow generation apparatus can generate the first airflow flowing through the first region and the second airflow flowing through the second region, and the first airflow and the second airflow both flow in from the first side of the first cavity and flow out from the second side of the first cavity, so that the first region can be subjected to heat management by using the first airflow, the second region can be subjected to heat management by using the second airflow, and then, the first region and the second region can be subjected to heat management in a targeted manner. Meanwhile, since the average heat generation of the devices arranged in the first region is greater than the average heat generation of the devices arranged in the second region, more of the first airflow can flow into and flow out of the first channel defined by the cover by arranging the cover in the first region, so that a heat management effect of the first region can be improved, and then, a heat management effect of the energy storage converter can be improved on the whole.

Additional aspects and advantages of embodiments of the present disclosure will be given in part in the following descriptions, become apparent in part from the following descriptions, or be learned from the practice of the embodiments of the present disclosure.

### BRIEF DESCRIPTION OF DRAWINGS

Through reading detailed descriptions of the following embodiments, those of ordinary skill in the art may understand various advantages and benefits. The accompanying drawings are merely intended to illustrate objectives of the embodiments, but are not interpreted as limitations on the present disclosure. In addition, the same reference sign is used to indicate the same member throughout the accompanying drawings. In the drawings:
FIG. 1 is a schematic perspective structural diagram of an energy storage converter according to one or more embodiments of the present disclosure from one perspective;
FIG. 2 is a schematic perspective structural diagram of the energy storage converter according to one or more embodiments of the present disclosure from another perspective;
FIG. 3 is a schematic perspective structural diagram of the energy storage converter according to one or more embodiments of the present disclosure from one perspective with a part of a structure removed;
FIG. 4 is a schematic perspective structural diagram of the structure shown in FIG. 3 with a cover removed;
FIG. 5 is a schematic perspective structural diagram of the energy storage converter according to one or more embodiments of the present disclosure with a part of the structure removed;
FIG. 6 is a schematic structural diagram of FIG. 5 with a reference plane removed;
FIG. 7 is a schematic diagram of a projection relationship between an opening and the cover in one or more embodiments of the present disclosure;
FIG. 8 is a schematic side structural diagram of the structure illustrated in FIG. 3;
FIG. 9 is a schematic diagram of a projection relationship between the opening and an avoiding portion in one or more embodiments of the present disclosure;
FIG. 10 is a schematic diagram of a projection relationship between a notch portion and the opening in one or more embodiments of the present disclosure;
FIG. 11 is a schematic structural diagram of FIG. 8 with the cover removed;
FIG. 12 is a schematic partial enlarged structural diagram of U in FIG. 11;
FIG. 13 is a schematic perspective structural diagram of the energy storage converter according to one or more embodiments of the present disclosure from another perspective with a part of the structure removed;
FIG. 14 is a schematic diagram of airflow flowing of the energy storage converter according to one or more embodiments of the present disclosure;
FIG. 15 is a schematic diagram of a projection relationship between a first communication hole and an object device in one or more embodiments of the present disclosure;
FIG. 16 is a schematic diagram of a projection relationship between a second communication hole and the object device in one or more embodiments of the present disclosure;
FIG. 17 is a schematic diagram of the airflow flowing of the energy storage converter according to one or more embodiments of the present disclosure;
FIG. 18 is a schematic perspective structural diagram in which an air cooling module, a second partition wall, and a device are fitted in one or more embodiments of the present disclosure;
FIG. 19 is another schematic side structural diagram of a partial structure of the energy storage converter according to one or more embodiments of the present disclosure;
FIG. 20 is a schematic structural diagram in which a second generation unit and a first partition wall are fitted in one or more embodiments of the present disclosure;
FIG. 21 is a schematic diagram of the airflow flowing of the energy storage converter according to one or more embodiments of the present disclosure;
FIG. 22 is a schematic diagram of the airflow flowing of the energy storage converter according to one or more embodiments of the present disclosure; and
FIG. 23 is a schematic diagram of the airflow flowing of the energy storage converter according to one or more embodiments of the present disclosure.

### Reference signs:

Energy storage converter 100;
housing 110, first wall 111, second wall 112, third wall 113, fourth wall 114, fifth wall 115, sixth wall 116, first cavity Q1, first region z1, second region z2, first sub-region z21, second sub-region z22, first side c1, second side c2, first sub-cavity Q11, second sub-cavity Q12, wall structure a, accommodating cavity Q13, second cavity Q2, third side c3, fourth side c4, first ventilation opening h1, second ventilation opening h2, third ventilation opening h3, fourth ventilation opening h4;
device 120, target device n1, object device n2;
airflow generation apparatus 130, first generation unit 131, first generation member 1311, second generation member 1312, first airflow g1, second generation unit 132, air inlet f, first sub-inlet f1, second sub-inlet f2, second airflow g2;
cover 140, first channel p1, stair portion s, first cover section 141, second cover section 142, avoiding portion m, notch portion g;
first partition wall 150, first edge b1, second edge b2, third edge b3, fourth edge b4, first partition portion 151, second partition portion 152, opening k, air guide port w1;
air guide member 160, first end e1, second end e2;
second partition wall 170, first communication hole t1, open portion X;
air cooling module 180, fan 181, heat sink 182, third airflow g3;
temperature detection member I;
object circuit board Dm, second communication hole t2, first circuit board D1, second circuit board D2, third circuit board D3, fourth circuit board D4, second channel p2, air introduction hole w2, fifth circuit board D5, sixth circuit board D6;
reference plane J, reference plane E, first projection y1, second projection y2, third projection y3, fourth projection y4, fifth projection y5, sixth projection y6, seventh projection y7;
first direction F1, second direction F2, third direction F3.

### DESCRIPTION OF EMBODIMENTS

In order to make the aforementioned objects, features and advantages of the present disclosure more apparent, embodiments of the present disclosure are described below in detail with reference to the accompanying drawings. In the following description, numerous specific details are set forth, so as to provide a thorough understanding of the present disclosure. However, the present disclosure may be implemented in many ways different from those described herein, those skilled in the art may make similar improvements without departing from the essence of the present disclosure, and therefore, the present disclosure is not limited to the embodiments disclosed below.

In the description of the present disclosure, it should be understood that the orientation or position relationship indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are only intended to facilitate the description of the present disclosure and simplify the description, rather than indicating or implying that the apparatus or element referred to must have a particular orientation or be constructed and operated in a particular orientation, and therefore are not to be interpreted as limitations on the present disclosure.

In addition, terms "first" and "second" are used herein for purposes of description and shall not be construed as indicating or implying a relative importance, or implicitly specifying the number of the indicated technical features. Thus, the feature defined with "first" and "second" may include at least one of this feature explicitly or implicitly. In the description of the present disclosure, "a plurality of" means at least two, such as two, three, or the like, unless specifically stated otherwise.

In the present disclosure, unless specifically stated and limited, the terms "mounting," "coupling", "connecting" and "fixing" should be understood in a broad sense. For example, it can be a fixed connection, a detachable connection, or an integral connection; a mechanical connection or an electrical connection; a direct connection, an indirect connection through an intermediate medium, an internal connection of two elements, or an interaction of two elements, unless specifically limited. For those of ordinary skill in the art, the specific meanings of the above terms in the present disclosure can be understood on housing-by-housing.

In the present disclosure, unless specifically stated and limited, the description that a first feature is "on" or "below" a second feature may mean that the first feature is in direct contact with the second feature, or the first feature and the second feature are in indirect contact via an intermediate medium. Furthermore, a first feature "on," "above," or "on top of" a second feature may include an embodiment in which the first feature is right or obliquely "on," "above," or "on top of" the second feature, or just means that the first feature is at a height higher than that of the second feature. A first feature "below," "under," or "on bottom of" a second feature may include an embodiment in which the first feature is right or obliquely "below," "under," or "on bottom of" the second feature, or just means that the first feature is at a height lower than that of the second feature.

It should be noted that when an element is referred to as being "fixed on" or "provided at" another element, the element may be directly located on the other element or an intermediate element may exist. If one element is considered to be "connected" to another element, it may be directly connected to the another element or an intermediate element may co-exist. As used herein, the terms "vertical", "horizontal", "upper", "lower", "left", "right", or the like, are for purposes of illustration only and do not denote a sole embodiment.

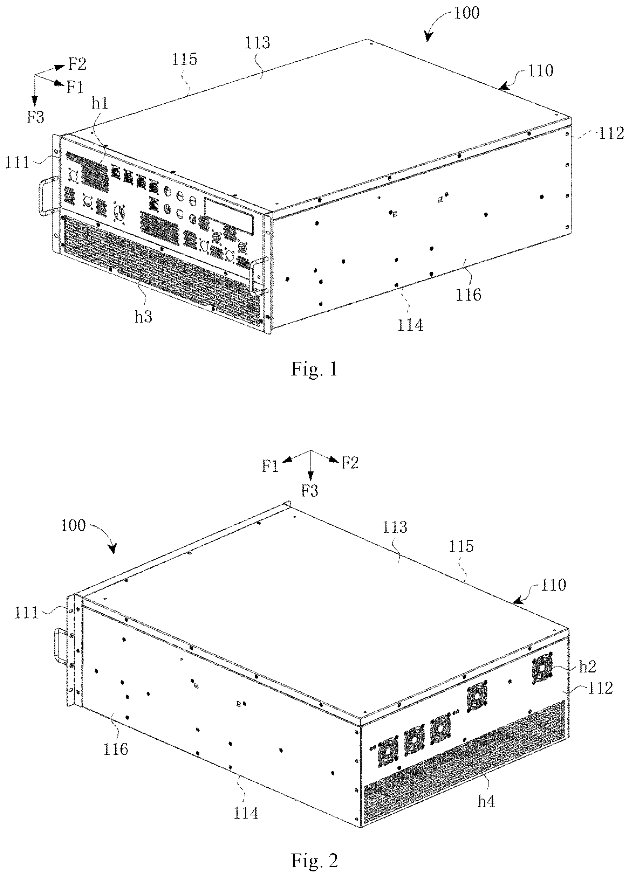

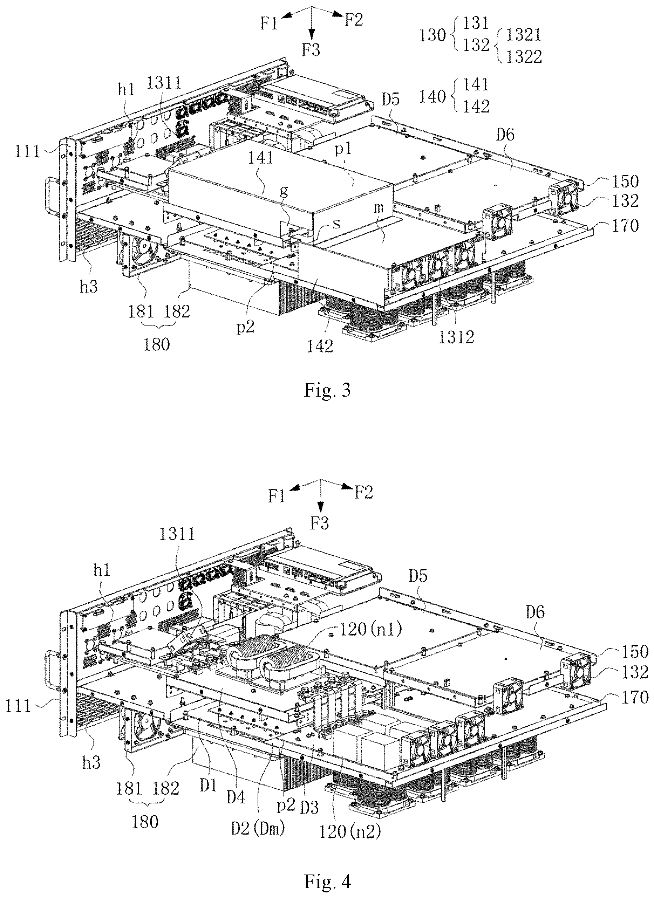

According to some embodiments of the present disclosure, referring to FIG. 1 to FIG. 4 in which FIG. 1 is a schematic perspective structural diagram of an energy storage converter 100 according to one or more embodiments of the present disclosure from one perspective, FIG. 2 is a schematic perspective structural diagram of the energy storage converter 100 according to one or more embodiments of the present disclosure from another perspective, FIG. 3 is a schematic perspective structural diagram of the energy storage converter 100 according to one or more embodiments of the present disclosure from one perspective with a part of a structure removed, and FIG. 4 is a schematic perspective structural diagram of the structure shown in FIG. 3 with a cover 140 removed, the embodiments of the present disclosure provide the energy storage converter 100, including a housing 110, a plurality of devices 120, an airflow generation apparatus 130 and the cover 140.

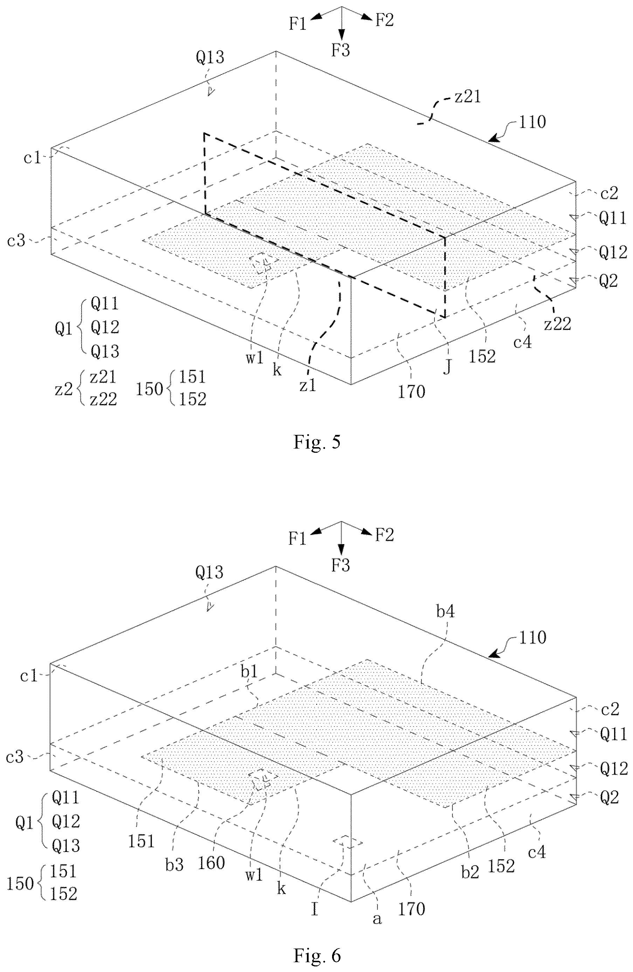

The housing 110 is a structure for accommodating related components in the energy storage converter 100. With combined reference to FIG. 5 which is a schematic perspective structural diagram of the energy storage converter 100 according to one or more embodiments of the present disclosure with a part of the structure removed, the housing 110 has a first cavity Q1, the first cavity Q1 includes a first region z1 and a second region z2 arranged along a first direction F1, the first cavity Q1 has a first side c1 and a second side c2 oppositely arranged along a second direction F2, and the first direction F1 and the second direction F2 intersect with each other.

In FIG. 5, for convenience of explaining the division of the regions inside the housing 110, the division of the regions inside the housing 110 is illustrated with dotted lines. A reference plane J is illustrated in the first cavity Q1, the reference plane J is perpendicular to the first direction F1, and regions on both sides of the reference plane J along the first direction F1 are the first region z1 and the second region z2, respectively. It should be noted that the dotted lines in the reference plane J and the housing 110 are only used to show the first region z1 and the second region z2, and there is no distinct structural boundary in the housing 110 to distinguish the first region z1 and the second region z2. Certainly, related structures can be arranged in the housing 110 as the structural boundaries to define the first region z1 and the second region z2, which is not limited herein. Hereinafter, similar parts can be understood in a similar manner and is not repeated. The first direction F1 and the second direction F2 may be a length direction and a width direction of the housing 110, respectively, and the first direction F1 and the second direction F2 may be perpendicular to each other. It should be noted that sizes of the housing 110 in the length direction and the width direction may be equal or unequal, which is not limited herein.

For example, taking FIG. 1 and FIG. 2 as an example, the housing 110 includes a first wall 111 and a second wall 112 oppositely arranged along the second direction F2, a third wall 113 and a fourth wall 114 oppositely arranged along a third direction F3, and a fifth wall 115 and a sixth wall 116 oppositely arranged along the first direction F1. The first wall 111, the second wall 112, the third wall 113, the fourth wall 114, the fifth wall 115, and the sixth wall 116 are connected correspondingly to form the housing 110. The first direction F1, the second direction F2 and the third direction F3 are perpendicular pairwise. With combined reference to FIG. 5, at least a part of a side of the first wall 111 facing the interior of the housing 110 constitutes the first side c1 of the first cavity Q1, and at least a part of a side of the second wall 112 facing the interior of the housing 110 constitutes the second side c2 of the first cavity Q1. It may be understood that, from the perspective of FIG. 5, the first side c1 and the second side c2 are marked with dotted lines to indicate relative positions of both the first side c1 and the second side c2. Correspondingly, for example, the first cavity Q1, the first region z1, and the second region z2 are located inside the housing 110 and also marked with dotted lines. Hereinafter, similar parts can be understood in a similar manner and is not repeated.

The plurality of devices 120 are arranged in at least the first region z1 and the second region z2, and an average heat generation of all the devices 120 arranged in the first region z1 is greater than an average heat generation of all the devices 120 arranged in the second region z 2.

The devices 120 refer to various electronic elements, components, or assemblies that may be configured to form electronic devices, circuitry, or other apparatuses. The devices 120 may include a capacitor, a relay, a transformer, a Hall element, an insulated gate bipolar transistor (IGBT) module, a power tube, or the like, and are not limited herein. The plurality of devices 120 are arranged in at least the first region z1 and the second region z2, that is, the plurality of devices 120 include the devices 120 arranged in the first region z1 and the devices 120 arranged in the second region z2. The devices 120 arranged in the first region z1 may be of one type or of a plurality of types. The devices 120 arranged in the second region z2 may be of one type or of a plurality of types. In the situation illustrated in FIG. 4, only some of the devices 120 are shown.

It should be noted that, in the embodiments of the present disclosure, the generated heat amount refers to a generated heat value generated by the device 120 when the device 120 works to a stable state under a rated voltage (the generated heat value is relatively stable). Taking all the devices 120 arranged in the first region z1 as an example, the rated voltages corresponding to all the devices 120 arranged in the first region z1 may be different or the same. The average heat generation of all the devices 120 arranged in the first region z1 may be an average value of the generated heat values corresponding to all the devices 120 arranged in the first region z1 when all the devices 120 arranged in the first region z1 work to the stable state at the rated voltages corresponding to the devices 120. The "average heat generation of all the devices 120 arranged in the second region z2" can be understood by referring to the "average heat generation of all the devices 120 arranged in the first region z1", and is not repeated herein.

The airflow generation apparatus 130 is arranged in the first cavity Q1. The airflow generation apparatus 130 is configured to generate a first airflow flowing through the first region z1 and a second airflow flowing through the second region z2. The first airflow and the second airflow are configured to flow in from the first side c1 and out from the second side c2.

The airflow generation apparatus 130 is an apparatus capable of generating an airflow having certain parameters (such as a flow rate, a flow volume, a pressure, or the like). The airflow generation apparatus 130 may be a fan component. For example, with combined reference to FIG. 1 and FIG. 2, the first wall 111 is provided with a plurality of first ventilation openings h1 communicated with the first cavity Q1, and the second wall 112 is provided with a plurality of second ventilation openings h2 communicated with the first cavity Q1. Numbers, arrangements, and configurations of the first ventilation openings h1 and the second ventilation openings h2 are not limited herein. The first airflow and the second airflow are configured to flow in from the first side c1 and out from the second side c2, that is, the first airflow may flow into the first cavity Q1 via the corresponding first ventilation opening h1 and flow out of the first cavity Q1 from the corresponding second ventilation opening h2 via the first region z1, and the second airflow may flow into the first cavity Q1 via the corresponding first ventilation opening h1 and flow out of the first cavity Q1 from the corresponding second ventilation opening h2 via the second region z2.

The cover 140 is arranged at the first region z1 and defines a first channel p1. An airflow path defined by the first channel p1 constitutes at least a part of a flow path of the first airflow, and at least some of the devices 120 located in the first region z1 are located within the cover 140.

The cover 140 is a case or structure for covering, protecting or isolating a corresponding component or region. The airflow path defined by the first channel p1 constitutes at least a part of the flow path of the first airflow, which means that the cover 140 may cover the whole of the first region z1, or may cover a part of the first region z1. Still alternatively, a length of the cover 140 in the second direction F2 is smaller than or equal to a length of the first region z1 in the second direction F2. That is, the first airflow may flow at least in the first channel p1. The cover 140 may direct more of the airflow through the first channel p1.

Thus, the first cavity Q1 of the housing 110 is configured to include the first region z1 and the second region z2 which are arranged along the first direction F1, the airflow generation apparatus 130 can generate the first airflow flowing through the first region z1 and the second airflow flowing through the second region z2, and the first airflow and the second airflow both flow in from the first side c1 of the first cavity Q1 and flow out from the second side c2 of the first cavity Q1, so that the first region z1 can be subjected to heat management by using the first airflow, the second region z2 can be subjected to heat management by using the second airflow, and then, the first region z1 and the second region z2 can be subjected to heat management in a targeted manner. Meanwhile, since the average heat generation of the devices 120 arranged in the first region z1 is greater than the average heat generation of the devices 120 arranged in the second region z2, more of the first airflow can flow into and flow out of the first channel p1 defined by the cover 140 by arranging the cover 140 in the first region z1, so that a heat management effect of the first region z1 can be improved, and then, a heat management effect of the energy storage converter 100 can be improved on the whole.

According to some embodiments of the present disclosure, with continued reference to FIG. 3 to FIG. 5 and with combined reference to FIG. 6 which is a schematic structural diagram of FIG. 5 with the reference plane J removed, the energy storage converter 100 further includes a first partition wall 150, and the first partition wall 150 is arranged in the first cavity Q1, and divides the first cavity Q1 to define a first sub-cavity Q11 and a second sub-cavity Q12 which are arranged along the third direction F3. One parts of both the first sub-cavity Q11 and the second sub-cavity Q12 are located in the first region z1 and the other parts thereof are located in the second region z2. The first partition wall 150 is provided with an opening k, the opening k is located in the first region z1, and the opening k is communicated with the first sub-cavity Q11 and the second sub-cavity Q12. The cover 140 is at least arranged within the first sub-cavity Q11, and at least some of the devices 120 arranged within the first sub-cavity Q11 and located within the first region z1 are located within the cover 140. The opening k is communicated with the interior of the cover 140, and an orthogonal projection of the opening k on a reference plane E and an orthogonal projection of the cover 140 on the reference plane E have an overlapped part. The reference plane E is a plane perpendicular to the third direction F3, and the first direction F1, the second direction F2 and the third direction F3 intersect pairwise.

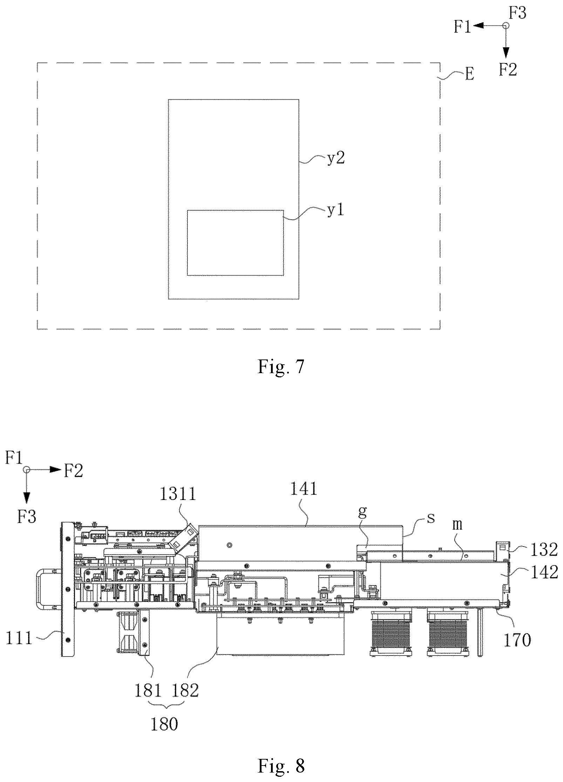

In FIG. 6, the first partition wall 150 located in the first cavity Q1 of the housing 110 is illustrated with dotted lines, and a part located in the first region z1 and a part located in the second region z2 are divided in the first partition wall 150 with dotted lines. With combined reference to FIG. 7 which is a schematic diagram of a projection relationship between the opening k and the cover 140 in one or more embodiments of the present disclosure, the orthographic projection of the opening k on the reference plane E is a first projection y1, the orthographic projection of the cover 140 on the reference plane E is a second projection y2, and the first projection y1 and the second projection y2 have an overlapped part. Taking FIG. 7 as an example, a situation that the first projection y1 is located within the second projection y2 is illustrated.

The cover 140 is at least arranged in the first sub-cavity Q11, that is, the whole cover 140 is arranged in the first sub-cavity Q11, or one part of the cover 140 is arranged in the first sub-cavity Q11, and the other part of the cover 140 is arranged in the second sub-cavity Q12 via the opening k, which is not limited herein. Taking FIG. 3 as an example, and with combined reference to FIG. 6, the situation that one part of the cover 140 is arranged in the first sub-cavity Q11, and the other part of the cover 140 is arranged in the second sub-cavity Q12 is illustrated.

By arranging the first partition wall 150, the first cavity Q1 can be divided to define the first sub-cavity Q11 and the second sub-cavity Q12, so that the devices 120 arranged in the first region z1 and the devices 120 arranged in the second region z2 can be arranged in a stacked manner, thereby facilitating an improvement of an overall space utilization rate and further obtaining a more compact structure. By providing the opening k in the first partition wall 150, and causing the opening k to be communicated with the interior of the cover 140, a part of the first airflow via the first channel p1 can pass from the first sub-cavity Q11 to the second sub-cavity Q12 under cooperation of the cover 140 and the opening k. When the airflow entering the first sub-cavity Q11 flows through the first channel p1 defined by the cover 140, a flow state of the airflow changes. When entering the second sub-cavity Q12 from the opening k, the airflow and the airflow in the second sub-cavity Q12 form certain disturbance and mixing, and the airflow disturbance facilitates heat exchange between the airflow and the devices 120 and promotes flowing of the airflow, thereby facilitating an improvement of a heat dissipation effect on the devices 120 arranged in the first region z1.

According to some embodiments of the present disclosure, with continued reference to FIG. 3 and FIG. 6 and with combined reference to FIG. 8 which is a schematic side structural diagram of the structure illustrated in FIG. 3, in a direction from the first side c1 to the second side c2, one part of the cover 140 is arranged in the first sub-cavity Q11, and at least a part of the other part of the cover 140 extends into the second sub-cavity Q12 through the opening k. At least some of the devices 120 arranged within the second sub-cavity Q12 are located within the cover 140. The direction from the first side c1 to the second side c2 is parallel to the second direction F2.

In some embodiments, taking FIG. 3 and FIG. 8 as an example, and with combined reference to FIG. 6, the cover 140 includes a first cover section 141 and a second cover section 142 which are arranged in sequence from the first side c1 to the second side c2, the first cover section 141 is arranged in the first sub-cavity Q11, and at least a part of the second cover section 142 extends into the second sub-cavity Q12 via the opening k.

Since at least a part of the other part of the cover 140 is located in the second sub-cavity Q12, the cover 140 can act on the first sub-cavity Q11 and the second sub-cavity Q12 at the same time, thus expanding an acting range of the cover 140. When the airflow flows through the first channel p1, the airflow can be guided by the other part of the cover 140 into the second sub-cavity Q12, thereby better facilitating formation of a disturbed and mixed airflow, and then better facilitating an improvement of a heat dissipation effect on the parts of the first sub-cavity Q11 and the second sub-cavity Q12 located in the first region z1.

Certainly, in some other embodiments, the second cover section 142 illustrated above may not extend into the second sub-cavity Q12, which is not limited herein.

According to some embodiments of the present disclosure, with continued reference to FIG. 3, FIG. 6, and FIG. 8, the cover 140 has a stair portion s. The stair portion s is configured to be able to direct the first airflow located in the first sub-cavity Q11 into the second sub-cavity Q12 via the opening k.

In some embodiments, the stair portion s is formed at least inside the cover 140. That is, the stair portion s may be formed on a surface of the interior of the cover 140, or the stair portion s may be formed on the entire wall of the cover 140, and at this point, the stair portion s may be visible from both the interior and the exterior of the cover 140. Taking the housing where the stair portion s is formed inside the cover 140 as an example, the stair portion s is a part having a step-like structure arranged inside the cover 140, and is generally composed of planes or curved surfaces having different heights, so as to form a step-like shape. A height, width, step number, or the like, of the stair portion s can be adjusted according to specific design requirements. Taking FIG. 3 and FIG. 8 as an example, the housing where the stair portion s can be seen both inside and outside the cover 140 is illustrated.

It can be understood that different step surfaces of the stair portion s can change a flow direction of the airflow, so that the first airflow located in the first sub-cavity Q11 enters the second sub-cavity Q12 through the opening k, so as to better cover the devices 120 requiring heat dissipation, and improve a utilization efficiency of the airflow. The airflow may be disturbed to some extent when passing through steps of the stair portion s. Such disturbance help to disrupt a boundary layer formed by the airflow on a surface of the cover 140, so as to increase heat exchange between the airflow and the cover 140 and the corresponding devices, thereby improving the heat dissipation effect. Further, the structure of the stair portion s may increase overall strength and stability of the cover 140. The stepped design enables the cover 140 to better distribute forces when subjected to an airflow impact or external pressure, thus reducing the likelihood of deformation or damage to the cover 140. For example, the stair portion s may function as a reinforcing rib for a thin cover 140, thereby improving deformation resistance of the cover 140. Furthermore, by providing the stair portion s inside the cover 140, it is also possible to arrange the devices according to heights and shapes of different devices.

Thus, by providing the stair portion s on the cover 140, not only flowing of the airflow can be optimized, but also the structural strength of the cover 140 can be increased and the space utilization rate can be improved.

According to some embodiments of the present disclosure, with continued reference to FIG. 3, FIG. 6, and FIG. 8, a part of the cover 140 arranged in the first sub-cavity Q11 is defined as the first cover section 141, and a part of the cover 140 extending into the second sub-cavity Q12 through the opening k is defined as the second cover section 142. The stair portion s is defined at the junction of the first cover section 141 and the second cover section 142.

The stair portion s is defined at the junction of the first cover section 141 and the second cover section 142, which not only is favorable for directing the airflow into the second sub-cavity Q12, but also may enhance structural strength of the junction. It can be understood that, since the airflow passes through the first cover section 141 and enters the second sub-cavity Q12 under the action of the second cover section 142, the junction of the first cover section 141 and the second cover section 142 may be subjected to a certain airflow acting force, and the formation of the stair portion s at the junction can further improve structural stability and reliability of the cover 140.

Certainly, in some other embodiments, the stair portion s may also be arranged on the first cover section 141 or the second cover section 142, which is not limited herein.

According to some embodiments of the present disclosure, with continued reference to FIG. 3 and FIG. 8, the cover 140 has an avoiding portion m, and an orthographic projection of the avoiding portion m on the reference plane E and the orthographic projection of the opening k on the reference plane E have an overlapped part.

The avoiding portion m is a structure in the cover 140 that can avoid other components in the first cavity Q1, and provides a corresponding space for the other components.

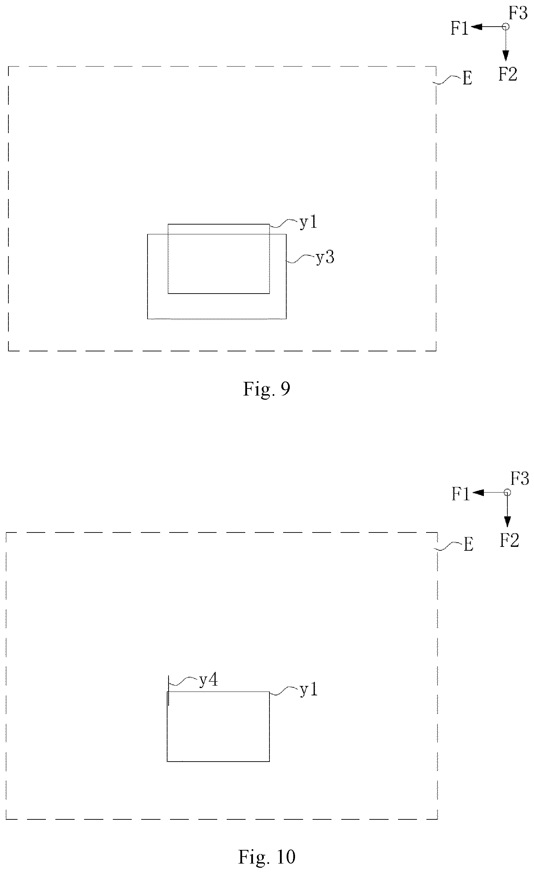

In some embodiments, with combined reference to FIG. 9 which is a schematic diagram of a projection relationship between the opening k and the avoiding portion m in one or more embodiments of the present disclosure, the orthographic projection of the opening k on the reference plane E is the first projection y1, the orthographic projection of the avoiding portion m on the reference plane E is a third projection y3, and the first projection y1 and the third projection y3 have an overlapped part.

Thus, by providing the avoiding portion m on the cover 140, it is possible to more fully utilize the space and to facilitate mounting and maintenance of other components in the first cavity Q1.

According to some embodiments of the present disclosure, with continued reference to FIG. 3, FIG. 6, and FIG. 8, the part of the cover 140 arranged in the first sub-cavity Q11 is defined as the first cover section 141, and the part of the cover 140 extending into the second sub-cavity Q12 through the opening k is defined as the second cover section 142. The second cover section 142 is located downstream of the first cover section 141 in a direction from the first sub-cavity Q11 to the second sub-cavity Q12 to define the avoiding portion m. The direction from the first sub-cavity Q11 to the second sub-cavity Q12 and the third direction F3 are parallel to each other.

Since the second cover section 142 is located downstream of the first cover section 141 in the direction from the first sub-cavity Q11 to the second sub-cavity Q12, there is a height difference between the first cover section 141 and the second cover section 142, thereby defining the avoiding portion m. With combined reference to the content illustrated in some embodiments described above, i.e., the stair portion s is defined at the junction of the first cover section 141 and the second cover section 142, related components within the first cavity Q1 can be conveniently mounted and enclosed, the space can be more fully used, and the advantages of the stair portion s in some embodiments described above can be achieved.

It may be appreciated that the stepped-down design allows for more precise control and direction of the airflow at different levels. At the stair portion s, the airflow undergoes a relatively independent change, thus enabling the airflow to flow in a specific manner. Compared with a cover 140 which smoothly descends or a cover 140 with a consistent top surface height, the descending stair portion s can cause the airflow to generate more obvious disturbance at the step, so that the airflow can better carry away heat to improve a heat dissipation efficiency.

Certainly, in some other embodiments, the avoiding portion m may be arranged on the first cover section 141 or defined by a part of the second cover section 142, which is not limited herein.

According to some embodiments of the present disclosure, with continued reference to FIG. 3, FIG. 6, and FIG. 8, the cover 140 is provided with a notch portion g along the first direction F1, and an orthographic projection of the notch portion g on the reference plane E and the orthographic projection of the opening k on the reference plane E have an overlapped part.

In some embodiments, with combined reference to FIG. 10 which is a schematic diagram of a projection relationship between the notch portion g and the opening k in one or more embodiments of the present disclosure, the orthographic projection of the opening k on the reference plane E is the first projection y1, the orthographic projection of the notch portion g on the reference plane E is a fourth projection y4, and the first projection y1 and the fourth projection y4 have an overlapped part. The notch portion g may be arranged on the first cover section 141, may be arranged on the second cover section 142, and may be defined by the first cover section 141 and the second cover section 142, which is not limited herein. Taking FIG. 3 as an example, the housing where the notch portion g is arranged at the first cover section 141 is illustrated.

By providing the notch portion g, the related devices covered by the cover 140 can be avoided, thereby facilitating the arrangement of the related devices. Since the orthographic projections of the notch portion g and the opening k on the reference plane E have an overlapped part, the notch portion g can avoid the relevant devices exposed through the opening k.

According to some embodiments of the present disclosure, with continued reference to FIG. 3, FIG. 6, and FIG. 8, the part of the cover 140 arranged in the first sub-cavity Q11 is defined as the first cover section 141, and the part of the cover 140 extending into the second sub-cavity Q12 through the opening k is defined as the second cover section 142. The first cover section 141 and the second cover section 142 are detachably connected.

For example, the first cover section 141 and the second cover section 142 may be detachably connected by a fastener, or in a snap-fit manner, an insertion manner, or the like, which is not limited herein.

Thus, by configuring the first cover section 141 and the second cover section 142 to be detachably connected, mounting of the cover 140 and maintenance of the device 120 covered by the cover 140 are facilitated. Further, when the stair portion s and/or the avoiding portion m are formed in the cover 140, mounting of the cover 140 and the related components is better facilitated.

Certainly, in some other embodiments, the first cover section 141 and the second cover section 142 may be of an integral structure, which is not limited herein.

According to some embodiments of the present disclosure, with continued reference to FIG. 5 and FIG. 6, the first partition wall 150 is spaced apart from the first side c1 of the first cavity Q1 in the direction from the first side c1 to the second side c2, so as to define an accommodating cavity Q13 for accommodating some of the devices 120. The first sub-cavity Q11 and the second sub-cavity Q12 are both in communication with the accommodating cavity Q13. In the direction from the first side c1 to the second side c2, the accommodating cavity Q13 is located upstream of the first sub-cavity Q11 and the second sub-cavity Q12, so that the first airflow flows into the first region z1 via the accommodating cavity Q13 and the second airflow flows into the second region z2 via the accommodating cavity Q13.

With combined reference to FIG. 1, after the airflow enters the accommodating cavity Q13 from the first ventilation opening h1, a speed of the airflow is reduced due to a sudden increase of a space, a pressure is buffered and stabilized, an influence of fluctuations of the airflow on an internal structure is reduced, the airflow entering the first cavity Q1 and a second cavity Q2 is more stable, and an improvement of stability and reliability of the whole system is facilitated.

By providing the accommodating cavity Q13, the airflow has a more sufficient time and space for convergence and adjustment before entering the first channel p1 defined by the cover 140. This helps to improve concentration and directionality of the airflow entering the cover 140, so that the cover 140 can better focus the airflow to the first region z1, and an air-gathering effect of the cover 140 is enhanced, thereby further improving the heat dissipation effect on the device 120 arranged in the first region z1. When more airflows flow into the cover 140, local pressure changes may be caused, and at this point, the accommodating cavity may be used for buffering, so as to improve stability and safety of the whole apparatus.

According to some embodiments of the present disclosure, with continued reference to FIG. 3 and FIG. 4, the airflow generation apparatus 130 includes a first generation unit 131. The first generation unit 131 includes a first generation member 1311 and a second generation member 1312. The first generation member 1311 is arranged corresponding to an inlet of the first channel p1, and the first generation member 1311 is configured to be able to deliver the first airflow to the first channel p1. The second generation member 1312 is arranged corresponding to an outlet of the first channel p1, and the second generation member 1312 is configured to output the first airflow within the first channel p1. In FIG. 3, a position of the first channel p1 is illustrated, and the dotted lines indicate that the first channel p1 is located inside the cover 140.

The first generation member 1311 and the second generation member 1312 may be configured as fan components. The first generation member 1311 is arranged corresponding to the inlet of the first channel p1, which means that the first generation member 1311 may be arranged at the inlet of the first channel p1, or may be arranged close to the inlet of the first channel p1, as long as the first airflow can be delivered to the first channel p1, which is not limited herein. The second generation member 1312 is arranged corresponding to the outlet of the first channel p1, which means that the second generation member 1312 may be arranged at the outlet of the first channel p1, or may be arranged close to the outlet of the first channel p1, as long as the first airflow in the first channel p1 can be output.

Flowing of the airflow within first channel p1 may be enhanced by coordination and cooperation of the first generation member 1311 and the second generation member 1312. The first generation member 1311 pushes the airflow into the first channel p1, the second generation member 1312 accelerates outflow of the airflow, and such a bidirectional action promotes steady and rapid flowing of the airflow within the cover 140, which improves the heat dissipation effect on the devices 120 arranged in the first region z1. Meanwhile, the flow volume, the flow rate, or the like, of the airflow flowing through the first channel p1 can be controlled by controlling operating parameters of the first generation member 1311 and the second generation member 1312, so that adjustment can be flexibly performed according to different working conditions, and adaptability and flexibility of the whole apparatus are improved. Furthermore, due to the arrangement of the first generation member 1311 and the second generation member 1312, if one of the first generation member 1311 and the second generation member 1312 fails, the other one can continue to strengthen the flowing of the airflow in the first channel p1 to some extent, and the stability and reliability of the whole apparatus are enhanced.

According to some embodiments of the present disclosure, with continued reference to FIG. 3, FIG. 4 and FIG. 6, the energy storage converter 100 further includes a temperature detection member I. The temperature detection member I is arranged corresponding to the opening k, and the temperature detection member I is configured to detect a temperature of the device 120 exposed through the opening k. The first generation member 1311 is configured to be able to adjust a working state in response to detection information of the temperature detection member I.

The temperature detection member I is a member for measuring the temperature of the corresponding device 120. For example, the temperature detection member I may be a component, such as a thermocouple and a temperature sensor, which may be configured to detect the temperature. The corresponding device 120 may be any device 120 exposed through the opening k. In the embodiments of the present disclosure, the device 120 is a device 120 located most downstream in the direction from the first side c1 to the second side c2, i.e., the last device 120, among the devices 120 exposed via the opening k.

The working state includes an open state and a closed state, and the open state may include a plurality of sub-states. Intake air amounts generated by the first generation member 1311 and corresponding to the plurality of sub-states are different from each other. In the closed state, the first generation member 1311 generates no airflow. As an example, the first generation member 1311 is a fan component, and rotation speeds of the first generation member 1311 corresponding to the plurality of sub-states are different from each other. A rotation speed of the first generation member 1311 corresponding to the closed state is 0 revolutions per minute (RPM). By controlling the rotation speed of the first generation member 1311, the amount of intake air into the first channel p1 can be adjusted, thereby controlling heat dissipation intensity.

For example, when the temperature detection member I detects that the temperature is within a target range, the first generation member 1311 may suspend operation or operate at a reduced rotation speed for a certain period of time; when the temperature is outside the target range, the first generation member 1311 may be started and adjusted to a target rotation speed for heat dissipation. Certainly, the operation manner of the first generation member 1311 may be other manners, and is not limited herein.

The airflow flowing through the first channel p1 may flow through the device 120 exposed through the opening k via the opening k, and in the process, the airflow in the first channel p1 may dissipate heat from the device 120 located upstream of the opening k, and at this point, the airflow may be at a higher temperature than the inlet airflow into the first channel p1, so that heat dissipation of the device 120 exposed through the opening k may be more difficult than that of the upstream device 120. Therefore, by providing the temperature detection member I to adjust the working state of the first generation member 1311, dynamic adjustment of heat dissipation can be realized. When the temperature of the device 120 exposed through the opening k is high, the first generation member 1311 may be controlled to increase the amount of intake air, thereby improving the heat dissipation efficiency and taking away excess heat in time. When the temperature of the device 120 exposed through the opening k is low, the first generation member 1311 may be controlled to reduce the amount of intake air, which may not only save energy, but also facilitate realization of dynamic adjustment of heat dissipation within the entire first cavity Q1.

Certainly, in some other embodiments, numbers of the first generation members 1311 and the second generation members 1312 may be controlled, and the first generation members 1311 and the second generation members 1312 are combined to form the first generation unit 131 that may have different working states, so as to implement dynamic adjustment of the heat dissipation process, which is not limited herein.

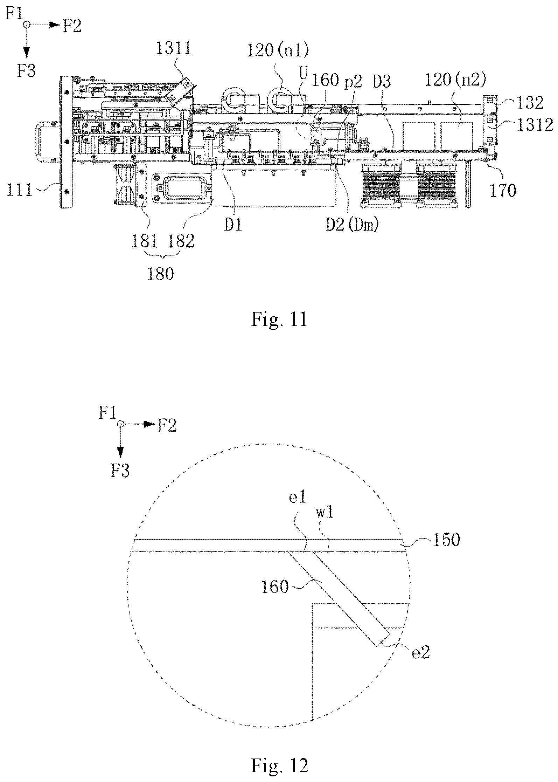

According to some embodiments of the present disclosure, with continued reference to FIG. 5 and FIG. 6 and with combined reference to FIG. 11 and FIG. 12 in which FIG. 11 is a schematic structural diagram of FIG. 8 with the cover 140 removed, and FIG. 12 is a schematic partial enlarged structural diagram of U in FIG. 11, an air guide port w1 is arranged in the first partition wall 150, and the air guide port w1 is communicated with the first sub-cavity Q11 and the second sub-cavity Q12. The air guide port w1 is located upstream of the opening k in the direction from the first side c1 to the second side c2. In FIG. 12, a position of the air guide port w1 is schematically illustrated roughly.

In the direction from the first side c1 to the second side c2, the first sub-cavity Q11 and the second sub-cavity Q12 are located upstream of the opening k and located in a part of the first region z1, and a part of the cover 140 is arranged within the first sub-cavity Q11 (which can be understood with reference to the first cover section 141 illustrated in some foregoing embodiments), so that more of the airflow passes more easily through the first sub-cavity Q11. Therefore, by providing the air guide port w1 upstream of the opening k, a part of the airflow in the first sub-cavity Q11 can be guided to the second sub-cavity Q12, so that a bottom side of the device 120 arranged at the opening k can be cooled, and the heat dissipation effect on the device 120 at the opening k can be further improved. The bottom side of the device 120 arranged at the opening k refers to a side of the device 120 away from the first sub-cavity Q11.

According to some embodiments of the present disclosure, with continued reference to FIG. 5, FIG. 6, FIG. 11, and FIG. 12, the air guide port w1 is located downstream of a target device n1 along the direction from the first side c1 to the second side c2. The target device n1 is a device 120 located upstream of the opening k in the direction from the first side c1 to the second side c2 among the devices arranged in the first sub-cavity Q11 and located in the first region z1 and the cover 140.

By arranging the air guide port w1 downstream of the target device n1, after the airflow flows through the target device n1, a part of the airflow enters the second sub-cavity Q12 through the air guide port w1, so that heat dissipation of the target device n1 is facilitated, and heat dissipation of the device 120 at the opening k can be realized.

It should be noted that the target device n1 may be determined according to the device 120 with the largest average heat generation among the devices which are arranged in the first sub-cavity Q11 and located in the first region z1 and the cover 140. Certainly, the target device may not be the device 120 having the largest average heat generation, which is not limited herein.

According to some embodiments of the present disclosure, with continued reference to FIG. 3 to FIG. 6 and FIG. 11, the devices arranged in the first sub-cavity Q11 and located in the first region z1 and the cover 140 are located upstream of the opening k along the direction from the first side c1 to the second side c2.

Thus, the airflow flowing into the first sub-cavity Q11 and located in the first region z1 can firstly dissipate heat of the devices arranged in the first sub-cavity Q11 and located in the first region z1 and the cover 140, and then enters the second sub-cavity Q12 through the opening k. In this way, heat dissipation of the devices arranged in the first sub-cavity Q11 and located in the first region z1 and the cover 140 is facilitated, and the arrangement of the cover 140 and the related devices is facilitated, so that the overall structure is more compact.

Certainly, in some other embodiments, the devices arranged in the first sub-cavity Q11 and located in the first region z1 and the cover 140 may be partially located upstream of the opening k and partially located downstream of the opening k, which is not limited herein.

According to some embodiments of the present disclosure, with continued reference to FIG. 6, FIG. 11 and FIG. 12, the energy storage converter 100 further includes an air guide member 160. The air guide member 160 is arranged at an edge of the air guide port w1 and located in the second sub-cavity Q12. The air guide member 160 has a first end e1 and a second end e2 oppositely arranged along an extension direction of the air guide member 160. The first end e1 is connected to the edge of the air guide port w1. The first end e1 is located upstream of the second end e2 in the direction from the first side c1 to the second side c2. A direction from the first end e1 to the second end e2 and the third direction F3 intersect with each other.

The air guide member 160 is a component for guiding the flow direction of the airflow and controlling distribution of the airflow.

Since the first end e1 is located upstream of the second end e2 in the direction from the first side c1 to the second side c2, and the direction from the first end e1 to the second end e2 and the third direction F3 intersect with each other, the air guide member 160 is arranged obliquely with respect to the first partition wall 150. The arrangement of the obliquely arranged air guide member 160 is favorable for guiding the airflow flowing into the second sub-cavity Q12 from the air guide port w1 to the device 120 arranged corresponding to the opening k, thereby facilitating an improvement of the heat dissipation effect on the device 120 arranged corresponding to the opening k.

It should be noted that the configuration of the air guide member 160 is not limited as long as it is favorable for guiding the airflow flowing into the second sub-cavity Q12 from the air guide port w1 to the device 120 arranged corresponding to the opening k. For example, the air guide member 160 may extend in a linear direction at the first end e1 and the second end e2. Certainly, the air guide member 160 may extend between the first end e1 and the second end e2 in an arc shape, which is not limited herein.

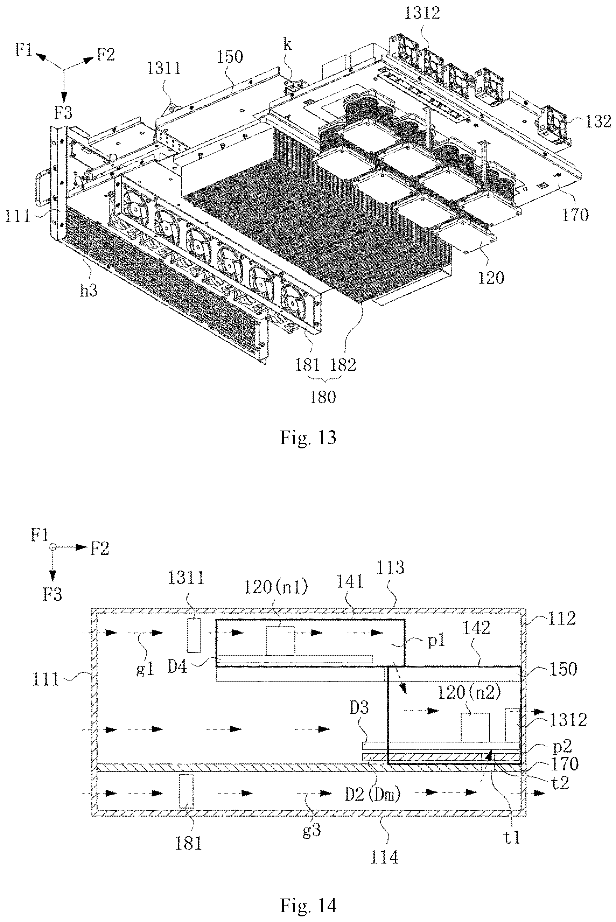

According to some embodiments of the present disclosure, with continued reference to FIG. 3 to FIG. 6, FIG. 8 and FIG. 11, and with combined reference to FIG. 13 which is a schematic perspective structural diagram of the energy storage converter 100 according to one or more embodiments of the present disclosure from another perspective with a part of the structure removed, the energy storage converter 100 further includes a second partition wall 170. The second partition wall 170 is arranged in the housing 110 and divides the housing 110 to define the first cavity Q1 and the second cavity Q2 which are arranged in the third direction F3. In a direction from the second sub-cavity Q12 to the first sub-cavity Q11, the second cavity Q2 is located upstream of the first cavity Q1. The second cavity Q2 has a third side c3 and a fourth side c4 oppositely arranged along the second direction F2. The energy storage converter 100 further includes an air cooling module 180 arranged in the second cavity Q2, and the air cooling module 180 is configured to generate a third airflow flowing into the second cavity Q2 from the third side c3 and flowing out from the fourth side c4. A direction from the third side c3 to the fourth side c4 is the same as the direction from the first side c1 to the second side c2. The direction from the third side c3 to the fourth side c4 and the second direction F2 are parallel to each other.

For example, with combined reference to FIG. 1 and FIG. 2, the first wall 111 of the housing 110 is provided with a third ventilation opening h3 communicated with the second cavity Q2, and the second wall 112 is provided with a fourth ventilation opening h4 communicated with the second cavity Q2. The airflow generated by the air cooling module 180 flows into the second cavity Q2 through the third ventilation opening h3, and flows out of the second cavity Q2 through the fourth ventilation opening h4.

In this way, by providing the second cavity Q2 and providing the air cooling module 180 in the second cavity Q2, the first partition wall 150 can be cooled by means of the air cooling module 180, thereby further improving a heat dissipation effect on the first cavity Q1.

It should be noted that the second cavity Q2 may or may not be provided with a device therein. When the device is arranged in the second cavity Q2, the device arrangement in the whole apparatus is facilitated, and the air cooling module 180 can be further used to dissipate heat of the device in the second cavity Q2, thereby further improving an overall heat dissipation effect of the apparatus.

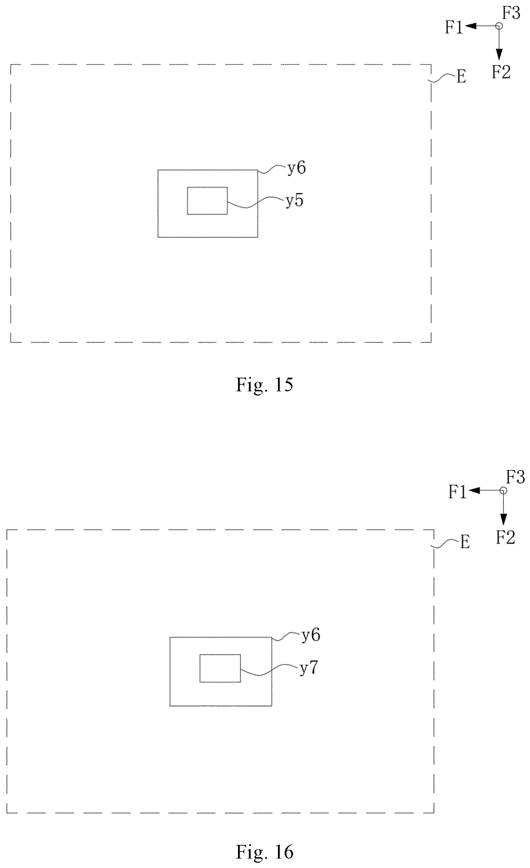

According to some embodiments of the present disclosure, with continued reference to FIG. 3, FIG. 4, FIG. 6, FIG. 11, and FIG. 13, and with combined reference to FIG. 14 and FIG. 15 in which FIG. 14 is a schematic diagram of airflow flowing of the energy storage converter 100 according to one or more embodiments of the present disclosure, and FIG. 15 is a schematic diagram of a projection relationship between a first communication hole t1 and an object device n2 in one or more embodiments of the present disclosure, the second partition wall 170 is provided with the first communication hole t1 communicated with the first cavity Q1 and the second cavity Q2. An orthogonal projection of the first communication hole t1 on the reference plane E and an orthogonal projection of the object device n2 on the reference plane E have an overlapped part. The object device n2 is a device arranged on a part of the second partition wall 170 corresponding to the opening k in the third direction F3.

In some embodiments, with combined reference to FIG. 15, the orthographic projection of the first communication hole t1 on the reference plane E is a fifth projection y5, the orthographic projection of the object device n2 on the reference plane E is a sixth projection y6, and the fifth projection y5 and the sixth projection y6 have an overlapped part. In FIG. 15, the housing where the fifth projection y5 is located within the sixth projection y6 is illustrated.

Since the first communication hole t1 is communicated with the first cavity Q1 and the second cavity Q2, a part of the airflow generated by the air cooling module 180 in the second cavity Q2 can enter the first cavity Q1 via the first communication hole t1. Since the orthographic projections of the first communication hole t1 and the object device n2 have an overlapped part, the airflow entering the first cavity Q1 through the first communication hole t1 can dissipate heat of the object device n2, and then, the airflow generated by the air cooling module 180 can be further used for improving a heat dissipation effect on the object device n2.

It should be noted that, with combined reference to the content illustrated in some foregoing embodiments, the object device n2 may be the device 120 illustrated in some foregoing embodiments and exposed through the opening k. Correspondingly, related heat dissipation manners of the device 120 exposed through the opening k and the object device n2 may be implemented by referring to each other, and are not repeated herein.

According to some embodiments of the present disclosure, with continued reference to FIG. 4, FIG. 11 and FIG. 14, the energy storage converter 100 further includes an object circuit board Dm. The object circuit board Dm is arranged in the first region z1 and carried by the second partition wall 170. The object device n2 is located on a side of the object circuit board Dm away from the second partition wall 170. The object circuit board Dm is provided with a second communication hole t2 communicated with the first communication hole t1. An orthogonal projection of the second communication hole t2 on the reference plane E and the orthogonal projection of the object device n2 on the reference plane E have an overlapped part.

The object circuit board Dm may be a printed circuit board (PCB), can provide support for the devices 120 achieving different electrical functions, and meanwhile can be used as a carrier for the devices 120 to implement an electrical interconnection. The object circuit board Dm may be manufactured by a process, such as electronic printing, and may be arranged in a flat plate shape. The object device n2 is located on the side of the object circuit board Dm away from the second partition wall 170, which means that the object device n2 may be arranged on the object circuit board Dm, or the object device n2 may not be arranged on the object circuit board Dm, which is not limited herein. In the housing illustrated in FIG. 11 and FIG. 14, the object device n2 is not arranged on the object circuit board Dm, and the object device n2 is arranged on a third circuit board D3 on a side of the object circuit board Dm away from the second partition wall 170. Related embodiments of the third circuit board D3 can be understood with combined reference to embodiments illustrated later, and are not repeated herein.

In some embodiments, with combined reference to FIG. 16 which is a schematic diagram of a projection relationship between the second communication hole t2 and the object device n2 in one or more embodiments of the present disclosure, the orthogonal projection of the object device n2 on the reference plane E is the sixth projection y6, an orthogonal projection of the second communication hole t2 on the reference plane E is a seventh projection y7, and the sixth projection y6 and the seventh projection y7 have an overlapped part. In FIG. 16, the housing where the seventh projection y7 is located within the sixth projection y6 is illustrated.

By providing the object circuit board Dm, an electrical connection between the devices 120 achieving different electrical functions and the arrangement of the devices 120 are facilitated. By providing the second communication hole t2 communicated with the first communication hole t1 in the object circuit board Dm, the airflow in the second cavity Q2 can enter the first cavity Q1 through the first communication hole t1 and the second communication hole t2, and dissipate the heat of the object device n2, so that the whole structure is simpler and more compact while the heat dissipation effect is improved.

According to some embodiments of the present disclosure, with continued reference to FIG. 4 and FIG. 11, the energy storage converter 100 further includes a first circuit board D1, a second circuit board D2, a third circuit board D3 and a fourth circuit board D4. The devices 120 include a plurality of devices 120 arranged on the first circuit board D1, the second circuit board D2, the third circuit board D3 and the fourth circuit board D4, respectively. Along the direction from the first side c1 to the second side c2, the first circuit board D1 and the second circuit board D2 are arranged in the second sub-cavity Q12. Along the direction from the second sub-cavity Q12 to the first sub-cavity Q11, the second circuit board D2 and the third circuit board D3 are spaced apart, and the devices 120 arranged on the third circuit board D3 are exposed through the opening k. The fourth circuit board D4 is arranged in the first sub-cavity Q11 and located in the first region z1, and the fourth circuit board D4 is carried on the first partition wall 150. The second circuit board D2 is electrically connected between the first circuit board D1 and the third circuit board D3, and the third circuit board D3 is electrically connected between the second circuit board D2 and the fourth circuit board D4.

It should be note that, in the housing illustrated in FIG. 4 and FIG. 11, some devices 120 are omitted for the convenience of illustrating the first circuit board D1, the second circuit board D2, the third circuit board D3, and the fourth circuit board D4. The first circuit board D1, the second circuit board D2, the third circuit board D3, and the fourth circuit board D4 may be printed circuit boards, and may provide support for the devices 120 achieving different electrical functions, and meanwhile may serve as carriers for the devices 120 to implement electrical interconnections. Similarly, the first circuit board D1, the second circuit board D2, the third circuit board D3, and the fourth circuit board D4 may be manufactured by a process, such as electronic printing, and the first circuit board D1, the second circuit board D2, the third circuit board D3, and the fourth circuit board D4 may be arranged in a flat plate shape.

In this way, the first circuit board D1, the second circuit board D2, the third circuit board D3 and the fourth circuit board D4 are arranged according to the illustrated situation and fitted in the cover 140, which is beneficial to realizing an electrical connection and improving the heat dissipation effect. Compared with the arrangement that the first circuit board D1, the second circuit board D2, the third circuit board D3, and the fourth circuit board D4 are stacked at intervals or tiled, the arrangement of the circuit boards illustrated in the embodiments of the present disclosure is beneficial to realizing a more compact arrangement and improving a space utilization rate. In addition, such an arrangement of the circuit boards may also cooperate with the cover 140 to better facilitate a layout for heat dissipation control.

According to some embodiments of the present disclosure, with continued reference to FIG. 4 and FIG. 11, the first circuit board D1 and the fourth circuit board D4 are spaced apart and oppositely arranged along the direction from the second sub-cavity Q12 to the first sub-cavity Q11.

Therefore, a space utilization rate of the first cavity Q1 can be further improved, formation of the required opening k is facilitated, and the fourth circuit board D4 and the third circuit board D3 can be electrically connected conveniently. Furthermore, in the housing of forming the required opening k, it is beneficial to further improving the heat dissipation effect in cooperation with the related embodiments of the cover 140 illustrated in some foregoing embodiments.

Certainly, in some other embodiments, the first circuit board D1 and the fourth circuit board D4 may not be completely arranged oppositely along the direction from the second sub-cavity Q12 to the first sub-cavity Q11. For example, an orthogonal projection of the first circuit board D1 on the reference plane E and an orthogonal projection of the fourth circuit board D4 on the reference plane E have an overlapped part, and an orthogonal projection of the third circuit board D3 on the reference plane E and an orthogonal projection of the fourth circuit board D4 on the reference plane E have an overlapped part. A space inside the first sub-cavity Q11 may be utilized to correspondingly arrange the fourth circuit board D4, which is not limited herein.

According to some embodiments of the present disclosure, with continued reference to FIG. 4 and FIG. 11, the first circuit board D1 is configured as a power board, the second circuit board D2 is configured as a busbar board, the third circuit board D3 is configured as an alternating current output board, and the fourth circuit board D4 is configured as an electromagnetic interference suppression board.

The power board is mainly configured to convert and amplify input electric energy. The busbar board is mainly configured to distribute and collect currents. The alternating current output board is mainly configured to convert the processed electric energy into alternating current signals meeting requirements and outputting the alternating current signals to provide an alternating current power source for an external device. The alternating current output board may include a filtering circuit, an amplifying circuit, a modulating circuit, or the like. The electromagnetic interference suppression board is a circuit board for suppressing electromagnetic interference inside or outside the device, and can reduce an influence of the electromagnetic interference on the device itself and surrounding electronic devices.

The power board efficiently transmits the processed electric energy to the busbar board, the busbar board can evenly distribute the current to the alternating current output board, and such a connection manner can reduce line losses and improve stability and a high efficiency of current transmission between the boards. As a current distribution hub, the busbar board enables power output by the power board to be reliably distributed to the alternating current output board. The alternating current output board converts the processed electric energy into the alternating current signal for output, and is connected to the electromagnetic interference suppression board, and the output alternating current signal can be filtered and shielded by the electromagnetic interference suppression board, so that the influence of the electromagnetic interference on the alternating current signal is reduced, stability and accuracy of the output signal are improved, and signal quality is improved.

Therefore, by connecting the circuit boards in the above connection manner, maintenance or replacement is facilitated, and good maintainability and expandability are realized.

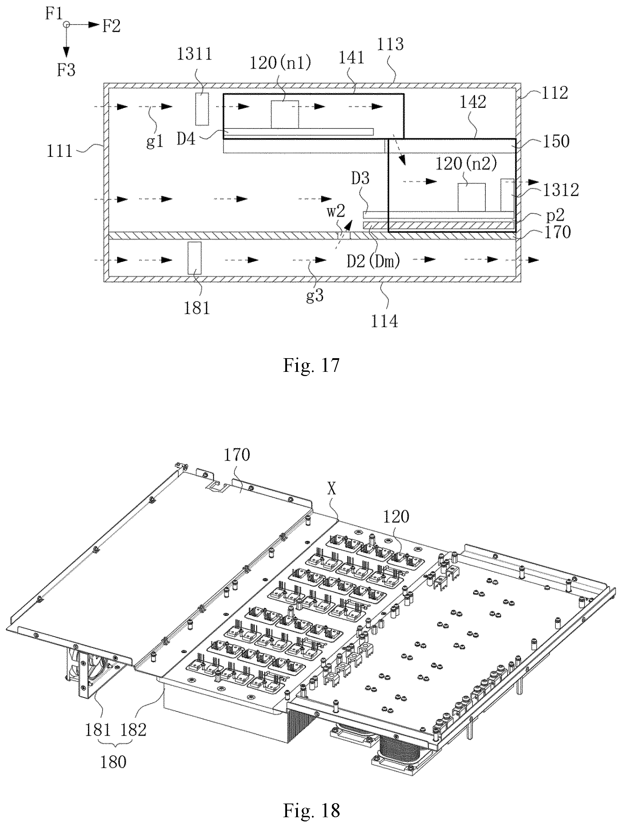

According to some embodiments of the present disclosure, with continued reference to FIG. 4 and FIG. 11, and with combined reference to FIG. 17 which is a schematic diagram of the airflow flowing of the energy storage converter 100 according to one or more embodiments of the present disclosure, the second circuit board D2 and the third circuit board D3 are spaced apart along the third direction F3 and define a second channel p2. The second sub-cavity Q12 is provided with a wall structure a which is opposite to and spaced apart from the first sub-cavity Q11 along the third direction F3, the wall structure a is provided with an air introduction hole w2 cooperating with the second channel p2, and the air introduction hole w2 is configured to introduce the airflow into the second channel p2.

In some embodiments, with combined reference to FIG. 17, the air introduction hole w2 may be located upstream of the second channel p2. Certainly, it is also possible to provide the corresponding first communication hole t1 and second communication hole t2 with combined reference to the contents illustrated in FIG. 14 and some foregoing embodiments, the first communication hole t1 can be regarded as the air introduction hole w2, and the second communication hole t2 can be arranged in the second circuit board D2. The second circuit board D2 can be regarded as the object circuit board Dm illustrated in some foregoing embodiments.

In this manner, by providing the air introduction hole w2, the airflow outside the first cavity Q1 can be introduced into the second channel p2, so that the heat dissipation of the second circuit board D2 and the third circuit board D3 can be further performed. When pins of the devices 120 arranged on the third circuit board D3 are located in the second channel p2, heat of the pins of the devices 120 can be further dissipated by using the airflow in the second channel p2, so as to improve the heat dissipation effect and improve heat accumulation at the pins of the devices 120. For example, the device 120 may be a relay.

According to some embodiments of the present disclosure, with continued reference to FIG. 4, FIG. 11, FIG. 13 and FIG. 17, the energy storage converter 100 further includes a second partition wall 170. The second partition wall 170 is arranged in the housing 110 and divides the housing 110 to define the first cavity Q1 and the second cavity Q2 which are arranged in the third direction F3. In the direction from the second sub-cavity Q12 to the first sub-cavity Q11, the second cavity Q2 is located upstream of the first cavity Q1. The second cavity Q2 has a third side c3 and a fourth side c4 oppositely arranged along the second direction F2, and a direction from the third side c3 to the fourth side c4 is the same as the direction from the first side c1 to the second side c2. The energy storage converter 100 further includes an air cooling module 180 arranged in the second cavity Q2, and the air cooling module 180 is configured to generate a third airflow flowing into the second cavity Q2 from the third side c3 and flowing out from the fourth side c4. A side of the second partition wall 170 facing the second sub-cavity Q12 constitutes the wall structure a, and the air introduction hole w2 is configured to introduce a part of the third airflow into the second channel p2.

Thus, the airflow generated by the air cooling module 180 can be further utilized to improve the heat dissipation effect on the second circuit board D2, the third circuit board D3 and the corresponding devices 120.

It should be noted that, in the housing of facilitating heat dissipation, the related embodiments of the air introduction hole w2, the second circuit board D2, the third circuit board D3, the object circuit board Dm, the first communication hole t1 and the second communication hole t2 may be implemented by referring to each other, which is not repeated herein and is not limited.

According to some embodiments of the present disclosure, with continued reference to FIG. 3, FIG. 4, FIG. 6, FIG. 11, and FIG. 13, the air cooling module 180 includes a fan 181 and a heat sink 182, and the devices 120 further include devices 120 arranged in the second cavity Q2. In the direction from the third side c3 to the fourth side c4, the fan 181, the heat sink 182 and the devices 120 arranged in the second cavity Q2 are arranged at intervals. A plurality of air guide channels extending from the third side c3 to the fourth side c4 are defined in the heat sink 182.

In this way, an airflow generated by operation of the fan 181 can flow along the air guide channel extending from the third side c3 to the fourth side c4 on the heat sink 182. The air guide channel achieves a good guide effect, so that the airflow can more accurately reach surfaces of the devices 120 required to be arranged in the second cavity Q2, which increases a contact efficiency of the airflow and the device 120, thereby taking away heat more effectively. Furthermore, the design of the air guide channel increases a contact area between the heat sink 182 and the airflow. When the airflow passes through the air guide channel, the airflow can perform more sufficient heat exchange with the heat sink 182, and the heat absorbed by the heat sink 182 is quickly taken away. Moreover, the ordered airflow flows in the channel, so that the heat exchange process can be more stable and efficient, thus further improving the heat dissipation effect.

According to some embodiments of the present disclosure, with continued reference to FIG. 6, and with combined reference to FIG. 18 which is a schematic perspective structural diagram in which the air cooling module 180, the second partition wall 170, and the device 120 are fitted in one or more embodiments of the present disclosure, the second partition wall 170 is provided with an open portion X, and the heat sink 182 is arranged on a side of the second partition wall 170 away from the second sub-cavity Q12. The open portion X is arranged corresponding to the heat sink 182 and exposes at least a part of a side of the heat sink 182 facing the second sub-cavity Q12. A plurality of devices 120 are arranged on the part of the heat sink 182 exposed through the open portion. For example, the device 120 arranged on the part of the heat sink 182 exposed through the open portion may be an IGBT.

In this way, the air cooling module 180 can be further utilized to dissipate the heat of the device 120 by utilizing the structure in which the open portion and the heat sink 182 cooperate, thereby further improving the heat dissipation effect.

It should be noted that the open portion may be a hole formed in the second partition wall 170, or may be defined by a split second partition wall 170. When the second partition wall 170 is of a split structure, the second partition wall 170 includes two parts connected to a side of the heat sink 182 facing the second sub-cavity Q12. In FIG. 18, the housing where the second partition wall 170 includes two parts is illustrated, which is not limited herein.

Certainly, in some other embodiments, a corresponding opening structure may be further arranged on the second partition wall 170, and the opening structure may be fitted with the device 120 or the circuit board in the second sub-cavity Q12, so as to further improve the heat dissipation effect.

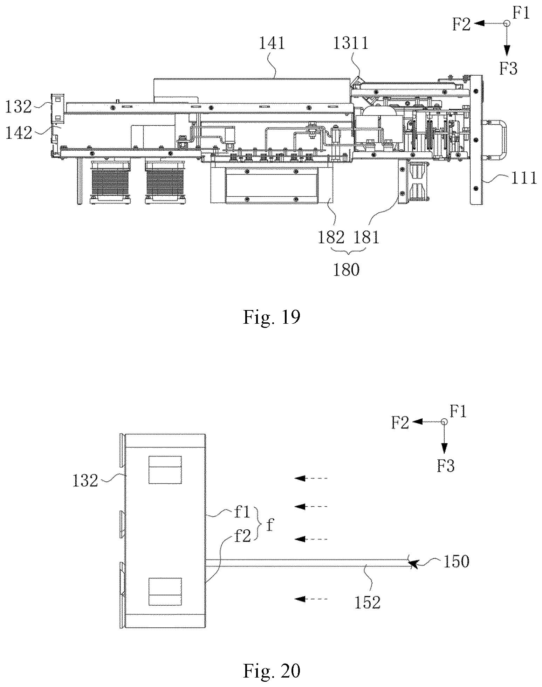

According to some embodiments of the present disclosure, with continued reference to FIG. 3 to FIG. 5, and with combined reference to FIG. 19 which is another schematic side structural diagram of a partial structure of the energy storage converter 100 according to one or more embodiments of the present disclosure, the second region z2 includes a first sub-region z21 located in the first sub-cavity Q11 and a second sub-region z22 located in the second sub-cavity Q12. An average heat generation of all the devices 120 arranged in the first sub-region z21 is greater than an average heat generation of all the devices 120 arranged in the second sub-region z22, and the second airflow generated by the airflow generation apparatus 130 is configured to flow through at least the first sub-region z21.

Since the average heat generation of all the devices 120 of the second region z2 is smaller than the average heat generation of all the devices 120 of the first region z1, the average heat generation of all the devices 120 of the second region z2 is relatively small. The second region z2 is divided into the first sub-region z21 and the second sub-region z22, and the devices 120 in the first sub-region z21 and the second sub-region z22 are further divided, so that the airflow can be correspondingly distributed according to the average heat generation. By causing the airflow to flow through at least the first sub-region z21, the airflow can be guided to the first sub-region z21 with a large generated heat amount in a targeted manner, and a cooling capacity of the airflow can be fully utilized to improve the heat dissipation effect.

It should be noted that, with combined reference to FIG. 3 to FIG. 5, a fifth circuit board D5 and a sixth circuit board D6 may be arranged on the first sub-region z21, and corresponding devices 120 may be arranged on the fifth circuit board D5 and the sixth circuit board D6. Likewise, the second sub-region z22 can also be provided with a related circuit board, which is not repeated herein.

According to some embodiments of the present disclosure, with continued reference to FIG. 3 to FIG. 5 and FIG. 19, the second airflow generated by the airflow generation apparatus 130 is configured to be able to flow through the first sub-region z21 and the second sub-region z22. A fluid path of the second airflow through the first sub-region z21 and a fluid path of the second airflow through the second sub-region z22 are arranged in the third direction F3.

The arrangement of the two fluid paths in the third direction F3 can reduce mutual interference of the airflows during flowing. Compared with other arrangements, such a manner can cause the airflow to flow through each sub-region more smoothly, improve turbulence and eddy phenomena of the airflow, reduce energy losses of the airflow, and improve the utilization efficiency of the airflow, thereby improving an integral heat dissipation performance.

According to some embodiments of the present disclosure, with continued reference to FIG. 3 to FIG. 5 and FIG. 19, and with combined reference to FIG. 20 which is a schematic structural diagram in which a second generation unit 132 and the first partition wall 150 are fitted in one or more embodiments of the present disclosure, the airflow generation apparatus 130 includes the second generation unit 132 arranged in the second region z2. The second generation unit 132 is located downstream of the first partition wall 150 in the direction from the first side c1 to the second side c2. One part of an air inlet f of the second generation unit 132 is communicated with the first sub-cavity Q11, and the other part of the air inlet f of the second generation unit 132 is communicated with the second sub-cavity Q12.

For example, the second generation unit 132 may be configured as a fan component.

The second generation unit 132 is located downstream of the first partition wall 150, one part of the air inlet f of the second generation unit is communicated with the first sub-cavity Q11, and the other part of the air inlet f is communicated with the second sub-cavity Q12, so that the airflows of the first sub-cavity Q11 and the second sub-cavity Q12 can be mixed at the second generation unit 132, so as to optimize airflow organization. By reasonably designing a proportion of the air inlet f, flow volumes of the airflows entering different sub-cavities of the second generation unit 132 can be adjusted to make the mixed airflow more uniform, thus improving a cooling effect on different heat generation regions. Furthermore, the second generation unit 132 is arranged in the second region z2 and located downstream of the first partition wall 150, so that a device internal space is effectively utilized, and a layout of the airflow generation apparatus 130 is more compact and reasonable. Such a layout can achieve a complex airflow distribution function in a limited space, thus improving the space utilization rate and facilitating a miniaturization design of the device.

According to some embodiments of the present disclosure, with continued reference to FIG. 19 and FIG. 20, the air inlet f of the second generation unit 132 includes a first sub-inlet f1 and a second sub-inlet f2 that are communicated with each other. The first sub-inlet F1 and the second sub-inlet F2 are arranged along the third direction F3, the first sub-inlet F1 is communicated with the first sub-cavity Q11, and the second sub-inlet F2 is communicated with the second sub-cavity Q12. An opening k area of the first sub-inlet f1 is greater than an opening k area of the second sub-inlet f2.

Since the average heat generation of the devices 120 of the first sub-region z21 is greater, and the opening k area of the first sub-inlet f1 is greater than that of the second sub-inlet f2, more of the airflow can enter the second generation unit 132 from the first sub-cavity Q11. This matches the requirement that the generated heat amount of the first sub-cavity Q11 is large and requires more cooling airflows, thus realizing more efficient heat dissipation, and maintaining temperatures of the regions balanced.

It can be understood that the average heat generation of the devices 120 of the first sub-region z21 is greater than that of the devices 120 of the second sub-region z22, and the average heat generation of the devices 120 of the first region is greater than that of the devices 120 of the first sub-region z21, so that structural arrangements of different levels of the regions are formed, the airflow is reasonably controlled according to a heating condition of each region, and therefore, the airflow can be fully utilized in the device. The condition that excessive airflows are wasted in the region with a small generated heat amount, and the airflow is insufficient in the region with a high generated heat amount is improved, an overall utilization efficiency of the airflow is improved, and energy consumption is reduced. Meanwhile, since the generated heat amounts of the devices in different regions are different, through the structural arrangement and the airflow control manner illustrated in some embodiments, the cooling airflow can be distributed more accurately according to actual heat dissipation requirements of the regions, thereby improving the heat dissipation effect of the whole apparatus and then improving the stability and reliability of the apparatus.

According to some embodiments of the present disclosure, with continued reference to FIG. 6, the first partition wall 150 has a first edge b1 and a second edge b2 oppositely arranged along the second direction F2, and a direction from the first edge b1 to the second edge b2 is the same as the direction from the first side c1 to the second side c2. The opening k is configured as a notch penetrating through at least the second edge b2.

The notch penetrates through the second edge b2, so that the airflow between the first sub-cavity Q11 and the second sub-cavity Q12 can be more smoothly circulated. Since the direction from the first edge b1 to the second edge b2 and the direction from the first side c1 to the second side c2 are the same, the airflow can be exchanged through the notch more directly in this direction, airflow obstruction is reduced, an airflow circulation efficiency is improved, uniform distribution of the airflow in the whole region is facilitated, and the heat dissipation effect is enhanced. Meanwhile, through the notch and in cooperation with the cover 140, the airflow can be reasonably distributed between the two sub-cavities according to design requirements, and the cooling airflow is more accurately guided to the region needing heat dissipation according to the generated heat amounts of the devices 120 in different sub-cavities. Furthermore, this simple notch structure is relatively easy to machine and manufacture, thus reducing difficulty and cost of manufacturing the first partition wall 150. Meanwhile, during mounting, this structure can be conveniently fitted with and assembled to other components, thus improving a mounting efficiency, and lowering complexity in the mounting process.

According to some embodiments of the present disclosure, with continued reference to FIG. 6, the first partition wall 150 further has a third edge b3 and a fourth edge b4 oppositely arranged along the first direction F1, the third edge b3 is farther away from the second region z2 than the fourth edge b4, and the third edge b3 and the fourth edge b4 are connected between the first edge b1 and the second edge b2. The opening k is configured as a notch penetrating through the second edge b2 and the third edge b3.

The opening k penetrates through the second edge b2 and the third edge b3, so that an airflow exchange area between the first sub-cavity Q11 and the second sub-cavity Q12 is greater, and the airflow can be mixed from more directions. Compared with the notch which only penetrates through the second edge b2, this structure can cause the airflow to form a more complex flow pattern in the cavity, and promote the airflows with different temperatures and speeds to be better mixed and then more evenly distributed to each sub-region, thereby further improving uniformity of heat dissipation. Moreover, in conjunction with the circuit boards and the corresponding devices 120 illustrated in some foregoing embodiments, the arrangement of the corresponding devices 120 and the connection between the circuit boards are also better facilitated.

According to some embodiments of the present disclosure, with continued reference to FIG. 6, the first partition wall 150 includes a first partition portion 151 and a second partition portion 152 connected to each other, the first partition portion 151 is located in the first region z1, and the second partition portion 152 is located in the second region z2. The first partition portion 151 and the opening k are sequentially arranged in the direction from the first edge b1 to the second edge b2. In FIG. 6, the first partition portion 151 and the second partition portion 152 are distinguished with dotted lines, but the present disclosure is not limited thereto. The direction from the first edge b1 to the second edge b2 and the second direction F2 are parallel to each other.

The first partition portion 151 and the opening k are sequentially arranged in the direction from the first edge b1 to the second edge b2, so that the airflow guided by the first partition portion 151 can more smoothly enter the second region z2 through the opening k, thus realizing ordered flowing of the airflow between different regions, improving the utilization efficiency of the airflow, and facilitating an improvement of the overall heat dissipation effect. Meanwhile, the devices 120 which are arranged in the first sub-cavity Q11 and located in the first region z1 can be arranged upstream of the opening k, which is not only beneficial to the arrangement of the devices 120, but also can improve the heat dissipation effect on the devices 120 which are arranged in the first sub-cavity Q11 and located in the first region z1.

Certainly, in some other embodiments, the opening k may also be partially arranged around the first partition portion 151, which is not limited herein.

The airflow path involved in the energy storage converter 100 according to the embodiments of the present disclosure is described below in connection with the content illustrated in some foregoing embodiments, but the present disclosure is not limited thereto.

In some embodiments, with continued reference to FIG. 14 and with combined reference to FIG. 1, FIG. 2, FIG. 5 and FIG. 6, the first airflow g1 enters the accommodating cavity Q13 through the first ventilation opening h1 on the first wall 111, one part of the first airflow g1 flows into a part of the first sub-cavity Q11 in the first region z1 through the accommodating cavity Q13, enters the second sub-cavity Q12 through the first channel p1 defined by the cover 140 and the opening k, and flows out from the second ventilation opening h2 on the second wall 112, and the other part of the first airflow g1 flows into a part of the second sub-cavity Q12 in the first region z1 through the accommodating cavity Q13, and flows out from the second ventilation opening h2 on the second wall 112 through the second cover section 142. The third airflow g3 enters the second cavity Q2 through the third ventilation opening h3 on the first wall 111, one part of the third airflow g3 enters the second channel p2 through the first communication hole t1 and the second communication hole t2 and flows out from the second ventilation opening h2 on the second wall 112, and the other part of the third airflow g3 flows out through the fourth ventilation opening h4 on the second wall 112.

In some embodiments, with continued reference to FIG. 17, the difference from the situation illustrated in FIG. 14 is that a part of the third airflow g3 enters the second channel p2 through the air guide hole w2 and flows out from the second ventilation opening h2 on the second wall 112.

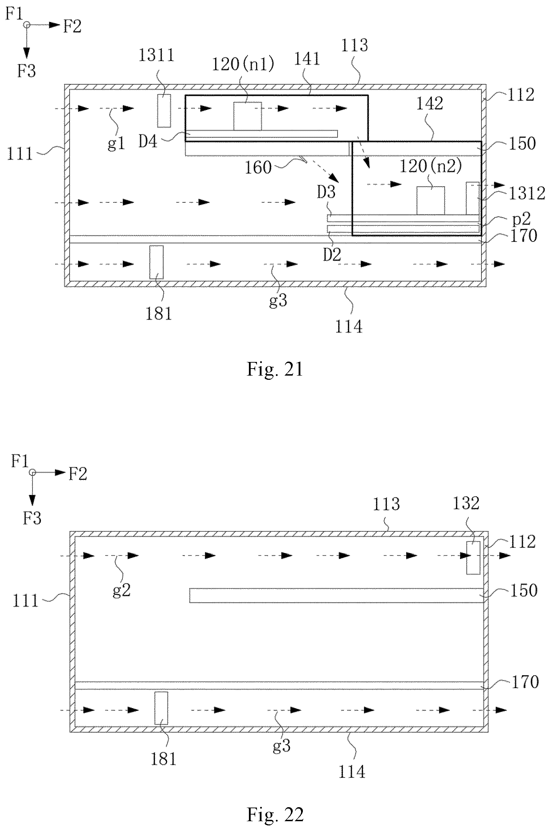

In some embodiments, referring to FIG. 21, and with combined reference to FIG. 12, FIG. 21 is a schematic diagram of the airflow flowing of the energy storage converter 100 according to one or more embodiments of the present disclosure, and the difference from the housing illustrated in FIG. 14 is that the third airflow g3 flows in and out of the second cavity Q2. A part of the first airflow g1 passing through the first cover section 141 enters the second sub-cavity Q12 through the air guide port w1 and the air guide member 160.

In some embodiments, referring to FIG. 22 which is a schematic diagram of the airflow flowing of the energy storage converter 100 according to one or more embodiments of the present disclosure, and the second airflow g2 enters the accommodating cavity Q13 through the first ventilation opening h1 on the first wall 111, and the second airflow g2 flows into the part of the first sub-cavity Q11 located in the second region z2 through the accommodating cavity Q13 and flows out from the second ventilation opening h2 on the second wall 112.

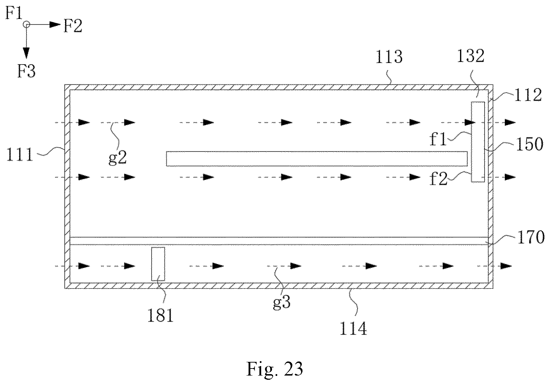

In some embodiments, referring to FIG. 23 which a schematic diagram of the airflow flowing of the energy storage converter 100 according to one or more embodiments of the present disclosure, the second airflow g2 enters the accommodating cavity Q13 through the first ventilation opening h1 on the first wall 111, one part of the second airflow g2 flows into a part of the first sub-cavity Q11 in the second region z2 through the accommodating cavity Q13 and flows out from the second ventilation opening h2 on the second wall 112, and the other part of the second airflow g2 flows into a part of the second sub-cavity Q12 in the second region z2 through the accommodating cavity Q13 and flows out from the second ventilation opening h2 on the second wall 112.

According to some embodiments of the present disclosure, with continued reference to FIG. 1, the energy storage converter 100 may have at least one of a photovoltaic interface, a battery interface, a grid input interface, a direct current output interface, and an alternating current output interface.

A solar cell or other renewable energy power generation systems may be connected through the photovoltaic interface, and the energy storage converter 100 may be connected to a battery through the battery interface. The battery can store electric energy, so that the electric energy of the battery can be converted and output through the energy storage converter 100 conveniently. The grid input interface can receive high-voltage electric energy of a grid which is output into a low-voltage electric device or system after a voltage reduction through the energy storage converter 100. The alternating current output interface may be connected to a product requiring an alternating current, such as a household appliance, and the energy storage converter 100 converts the alternating current into a direct current and outputs the direct current to the appliance. The direct current output interface can be connected to a device requiring a direct current, such as a charging pile.

Therefore, the energy storage converter 100 can be flexibly arranged according to actual use requirements, adaptability of the energy storage converter 100 is improved, use requirements under different scenarios are met, and no limitation is provided herein.

According to some embodiments of the present disclosure, the embodiments of the present disclosure provide an energy storage system, including the energy storage converter 100 according to any of the above embodiments.

In some embodiments, the energy storage system further includes a battery, and the energy storage converter 100 is electrically connected to the battery. The energy storage converter 100 can convert energy generated by solar power generation, wind power generation, fuel cells, or the like, into a direct current, and store the direct current into the battery, electric energy in the battery is output as required, and the energy storage system can provide reliable energy storage for a user, and provide a standby power source for the user when power is off or the power is insufficient, thus facilitating use of the user.

The energy storage system also has the advantages of the energy storage converter 100, which are not repeated herein.

The technical features of above-mentioned embodiments can be combined arbitrarily. In order to make the description concise, not all possible combinations of the technical features are described in embodiments. However, as long as there is no contradiction in the combination of these technical features, the combinations should be considered as in the scope of the specification.

Above-described embodiments are only several implementations of the present disclosure, and the descriptions are relatively specific and detailed, but they should not be construed as limiting the scope of the present disclosure. It should be understood by those of ordinary skill in the art that various modifications and improvements can be made without departing from the concept of the present disclosure, and all fall within the protection scope of the present disclosure. Therefore, the protection scope of the present disclosure should be subject to the appended claims.

## Claims

1. An energy storage converter, comprising:
a housing having a first cavity, wherein the first cavity comprises a first region and a second region arranged along a first direction, the first cavity has a first side and a second side oppositely arranged along a second direction, and the first direction and the second direction intersect each other;
a plurality of devices at least arranged in the first region and the second region, wherein an average heat generation of devices arranged in the first region is greater than an average heat generation of devices arranged in the second region;
an airflow generation apparatus arranged in the first cavity, wherein the airflow generation apparatus is configured to generate a first airflow flowing through the first region and a second airflow flowing through the second region, and the first airflow and the second airflow are each configured to flow in from the first side and out from the second side; and
a cover arranged in the first region and defining a first channel, wherein an airflow path defined by the first channel forms at least part of a flow path of the first airflow, and at least part of at least one of the devices located in the first region is located in the cover.

2. The energy storage converter according to claim 1, further comprising a first partition wall, wherein the first partition wall is arranged in the first cavity and divides the first cavity to define a first sub-cavity and a second sub-cavity arranged along a third direction;
one part of each of the first sub-cavity and the second sub-cavity is located in the first region, and another part of each of the first sub-cavity and the second sub-cavity is located in the second region;
the first partition wall is provided with an opening, the opening is located in the first region, and the opening is communicated with the first sub-cavity and the second sub-cavity; the cover is at least arranged in the first sub-cavity, and at least part of at least one of the devices arranged in the first sub-cavity and located in the first region is located in the cover;
the opening is communicated with an interior of the cover, and an orthographic projection of the opening on a reference plane overlaps with an orthographic projection of the cover on the reference plane; and the reference plane is a surface perpendicular to the third direction, and the first direction, the second direction and the third direction intersect pairwise.

3. The energy storage converter according to claim 2, wherein in a direction from the first side to the second side, one part of the cover is arranged in the first sub-cavity, and at least part of another part of the cover extends into the second sub-cavity via the opening; and
at least part of at least one of the devices arranged in the second sub-cavity is located in the cover.

4. The energy storage converter according to claim 3, wherein the cover has a stair portion; and the stair portion is configured to direct the first airflow located in the first sub-cavity into the second sub-cavity via the opening;
wherein part of the cover arranged in the first sub-cavity is defined as a first cover section, and part of the cover extending into the second sub-cavity via the opening is defined as a second cover section; and the stair portion is defined at a junction of the first cover section and the second cover section; or
wherein the cover has an avoiding portion; and an orthographic projection of the avoiding portion on the reference plane overlaps with an orthographic projection of the opening on the reference plane; wherein part of the cover arranged in the first sub-cavity is defined as a first cover section, and part of the cover extending into the second sub-cavity via the opening is defined as a second cover section; and in a direction from the first sub-cavity to the second sub-cavity, the second cover section is located downstream of the first cover section to define the avoiding portion; and/or the cover is provided with a notch portion along the first direction, and an orthographic projection of the notch portion on the reference plane overlaps with the orthographic projection of the opening on the reference plane have an overlapped part; or
wherein part of the cover arranged in the first sub-cavity is defined as a first cover section, and part of the cover extending into the second sub-cavity via the opening is defined as a second cover section; and the first cover section is detachably connected to the second cover section.

5. The energy storage converter according to any one of claims 2 to 4,
wherein in the direction from the first side to the second side, the first partition wall is spaced apart from the first side of the first cavity to define an accommodating cavity for accommodating at least one of the devices; and the first sub-cavity and the second sub-cavity are communicated with the accommodating cavity; and in the direction from the first side to the second side, the accommodating cavity is located upstream of the first sub-cavity and the second sub-cavity, such that the first airflow flows into the first region via the accommodating cavity, and the second airflow flows into the second region via the accommodating cavity;
wherein the airflow generation apparatus comprises a first generation unit; and the first generation unit comprises: a first generation member arranged corresponding to an inlet of the first channel, the first generation member is configured to deliver the first airflow to the first channel; and a second generation member arranged corresponding to an outlet of the first channel, the second generation member is configured to output the first airflow from the first channel;
wherein the energy storage converter further comprises a temperature detection member;
the temperature detection member is arranged corresponding to the opening, and configured to detect a temperature of an device exposed through the opening; and
the first generation member is configured to adjust a working state in response to detection information of the temperature detection member.

6. The energy storage converter according to any one of claims 2 to 4, wherein an air guide port is arranged in the first partition wall, and the air guide port communicates the first sub-cavity with the second sub-cavity; and the air guide port is located upstream of the opening in the direction from the first side to the second side.

7. The energy storage converter according to claim 6, wherein the air guide port is located downstream of a target device in the direction from the first side to the second side; and among the devices arranged in the first sub-cavity and located in the first region and the cover, the target device is a device located upstream of the opening in the direction from the first side to the second side;
wherein devices arranged in the first sub-cavity and located in the first region and the cover are all located upstream of the opening in the direction from the first side to the second side; or
the energy storage converter further comprises an air guide member; wherein the air guide member is arranged at an edge of the air guide port and located in the second sub-cavity; the air guide member comprises a first end and a second end which are oppositely arranged along an extension direction of the air guide member, and the first end is connected to the edge of the air guide port; the first end is located upstream of the second end in the direction from the first side to the second side; and the direction from the first end to the second end intersects with the third direction.

8. The energy storage converter according to any one of claims 2 to 4, further comprising a second partition wall;
wherein the second partition wall is arranged in the housing and divides the housing to define a first cavity and a second cavity which are arranged along a third direction; in a direction from the second sub-cavity to the first sub-cavity, the second cavity is located upstream of the first cavity; the second cavity has a third side and a fourth side which are oppositely arranged along the second direction;
wherein the energy storage converter further comprises an air cooling module arranged in the second cavity, and the air cooling module is configured to generate a third airflow flowing into the second cavity from the third side and flowing out from the fourth side; and
a direction from the third side to the fourth side is the same as the direction from the first side to the second side.

9. The energy storage converter according to claim 8,wherein the second partition wall is provided with a first communication hole for communicating the first cavity with the second cavity; and
an orthographic projection of the first communication hole on the reference plane overlaps with an orthographic projection of an object device on the reference plane; and
the object device is a device arranged on a part of the second partition wall corresponding to the opening in the third direction.

10. The energy storage converter according to claim 8, further comprising an object circuit board;
the object circuit board is arranged in the first region and carried by the second partition wall; the object device is located on a side of the object circuit board facing away from the second partition wall, and the object circuit board is provided with a second communication hole communicated with the first communication hole; and
an orthographic projection of the second communication hole on the reference plane overlaps with the orthographic projection of the object device on the reference plane.

11. The energy storage converter according to any one of claims 2 to 4, further comprising a first circuit board, a second circuit board, a third circuit board and a fourth circuit board; all the devices comprise devices which are respectively arranged on the first circuit board, the second circuit board, the third circuit board and the fourth circuit board;
the first circuit board and the second circuit board are arranged in the second sub-cavity along the direction from the first side to the second side; along the direction from the second sub-cavity to the first sub-cavity, the second circuit board and the third circuit board are spaced apart, and the devices arranged on the third circuit board are exposed through the opening; the fourth circuit board is arranged in the first sub-cavity and located in the first region, and the fourth circuit board is carried on the first partition wall; and
the second circuit board is electrically connected between the first circuit board and the third circuit board, and the third circuit board is electrically connected between the second circuit board and the fourth circuit board.

12. The energy storage converter according to claim 11, wherein the first circuit board is provided as a power board, the second circuit board is provided as a busbar board, the third circuit board is provided as an alternating current output board, and the fourth circuit board is provided as an electromagnetic interference suppression board; or
wherein along the third direction, the second circuit board and the third circuit board are spaced apart and define a second channel; and the second sub-cavity is provided with a wall structure which is opposite to and spaced apart from the first sub-cavity along the third direction, the wall structure is provided with an air introduction hole aligned with the second channel, and the air introduction hole is configured to direct an airflow into the second channel; and
wherein the energy storage converter further comprises a second partition wall;
the second partition wall is arranged in the housing and divides the housing to define a first cavity and a second cavity which are arranged along a third direction;
in a direction from the second sub-cavity to the first sub-cavity, the second cavity is located upstream of the first cavity; the second cavity comprises a third side and a fourth side which are oppositely arranged along the second direction, and a direction from the third side to the fourth side is the same as the direction from the first side to the second side;
wherein the energy storage converter further comprises an air cooling module arranged in the second cavity, and the air cooling module is configured to generate a third airflow flowing into the second cavity from the third side and flowing out from the fourth side; and
a side of the second partition wall towards the second sub-cavity forms the wall structure, and the air introduction hole is configured to introduce part of the third airflow into the second channel.

13. The energy storage converter according to any one of claims 2 to 4, wherein the second region comprises a first sub-region located in the first sub-cavity and a second sub-region located in the second sub-cavity; and
an average heat generation of the devices arranged in the first sub-region is greater than an average heat generation of the devices arranged in the second sub-region, and
the second airflow generated by the airflow generation apparatus is configured to flow through at least the first sub-region;
wherein the second airflow generated by the airflow generation apparatus is configured to flow through the first sub-region and the second sub-region; and
a fluid path of the second airflow flowing through the first sub-region and a fluid path of the second airflow flowing through the second sub-region are arranged in the third direction;
wherein the airflow generation apparatus comprises a second generation unit arranged in the second region;
the second generation unit is located downstream of the first partition wall in the direction from the first side to the second side; and one part of an air inlet of the second generation unit is communicated with the first sub-cavity, and another part of the air inlet of the second generation unit is communicated with the second sub-cavity.
wherein the air inlet of the second generation unit comprises a first sub-inlet and a second sub-inlet which are communicated with each other;
the first sub-inlet and the second sub-inlet are arranged along the third direction, the first sub-inlet is communicated with the first sub-cavity, and the second sub-inlet is communicated with the second sub-cavity; and an opening area of the first sub-inlet is greater than an opening area of the second sub-inlet.

14. The energy storage converter according to any one of claims 2 to 4, wherein the first partition wall comprises a first edge and a second edge oppositely arranged in the second direction, and a direction from the first edge to the second edge is the same as the direction from the first side to the second side; and
the opening is configured as a notch penetrating through at least the second edge;
wherein the first partition wall further comprises a third edge and a fourth edge oppositely arranged in the first direction, the third edge is farther away from the second region than the fourth edge, and both the third edge and the fourth edge are connected between the first edge and the second edge; and
the opening is configured as a notch penetrating through the second edge and the third edge;
wherein the first partition wall comprises a first partition portion and a second partition portion connected to each other,
wherein the first partition portion is located in the first region, and the second partition portion is located in the second region; and
the first partition portion and the opening are arranged in sequence along a direction from the first edge to the second edge.

15. An energy storage system, comprising the energy storage converter according to any one of claims 1 to 14.
